(19)

**Europäisches Patentamt**
**European Patent Office**
**Office européen des brevets**

(11) **EP 4 764 779 A1**

(12) **EUROPEAN PATENT APPLICATION**
published in accordance with Art. 153(4) EPC

(43) Date of publication:
**24.06.2026 Bulletin 2026/26**

(21) Application number: **25765943.3**

(22) Date of filing: **10.09.2025**

(51) International Patent Classification (IPC):
**G06F 1/16** (2006.01)    **G09F 9/30** (2006.01)
**F16C 11/04** (2006.01)    **H05K 5/02** (2006.01)

(52) Cooperative Patent Classification (CPC):
**F16C 11/04; G06F 1/16; G09F 9/30; H05K 5/02**

(86) International application number:
**PCT/KR2025/014097**

(87) International publication number:
**WO 2026/059313 (19.03.2026 Gazette 2026/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.09.2024 KR 20240124253
14.10.2024 KR 20240139221**

(71) Applicant: **Samsung Electronics Co., Ltd
Suwon-si, Gyeonggi-do 16677 (KR)**

(72) Inventors:
• **SONG, Minsuk**
**Suwon-si, Gyeonggi-do 16677 (KR)**
• **KIM, Jihoon**
**Suwon-si, Gyeonggi-do 16677 (KR)**

• **AHN, Jaeuk**
**Suwon-si, Gyeonggi-do 16677 (KR)**
• **JUNG, Soli**
**Suwon-si, Gyeonggi-do 16677 (KR)**
• **CHOI, Junyoung**
**Suwon-si, Gyeonggi-do 16677 (KR)**
• **YOON, Byounguk**
**Suwon-si, Gyeonggi-do 16677 (KR)**
• **JUN, Jaeyoung**
**Suwon-si, Gyeonggi-do 16677 (KR)**
• **CHOI, Jinug**
**Suwon-si, Gyeonggi-do 16677 (KR)**

(74) Representative: **HGF
HGF Limited
4th Floor, 1 City Square
Leeds LS1 2ES (GB)**

(54) **FOLDABLE ELECTRONIC DEVICE**

(57)    Disclosed is a foldable electronic apparatus. The apparatus includes: a foldable housing configured to include a first housing part, a second housing part and a third housing part; a first hinge structure configured to rotatably connect the first housing part and the second housing part with each other; a second hinge structure configured to rotatably connect the second housing part and the third housing part with each other and include a first hinge assembly; and a flexible display disposed across the first housing part and the second housing part. The first hinge assembly includes: a first fixing bracket; a first rotating arm having one end rotatably connected to a first side of the first fixing bracket and the other end fixed to the second housing part; a second rotating arm having one end rotatably connected to a second side of the first fixing bracket and the other end fixed to the third housing part.

FIG. 6B

## Description

[Technical Field]

The present disclosure relates to a foldable electronic apparatus including a wide hinge structure.

[Background Art]

An electronic apparatus including a large-screen display may increase usability by a user. As demand for an electronic apparatus having high portability increases, the electronic apparatus may include a deformable display. The deformable display may be deformable in a slidable manner, in a foldable manner, or in a rollable manner.

The above-described information may be provided as related art to assist in understanding of the present disclosure. No claim or determination is made as to whether any of the above-described content is applicable as prior art related to the present disclosure.

[Solution to Problem]

According to an embodiment of the present disclosure, provided is a foldable electronic apparatus including: a foldable housing configured to include a first housing part, a second housing part and a third housing part; a first hinge structure configured to rotatably connect the first housing part and the second housing part with each other; a second hinge structure configured to rotatably connect the second housing part and the third housing part with each other and include a first hinge assembly; a first hinge cover configured to cover the first hinge structure; a second hinge cover configured to cover the second hinge structure; and a flexible display disposed across the first housing part, the second housing part and the third housing part. The first hinge assembly may include: a first fixing bracket fixed to the second hinge cover; a first rotating arm having one end rotatably connected to a first side of the first fixing bracket and the other end fixed to the second housing part; a second rotating arm having one end rotatably connected to a second side of the first fixing bracket and the other end fixed to the third housing part; a first support plate rotatably connected to the first rotating arm; and a second support plate rotatably connected to the second rotating arm. The first support plate and the second support plate may be configured to: support the flexible display in an unfolded state where the second housing part and the third housing part are unfolded; and be spaced apart from each other in linkage with rotation of the second housing part and the third housing part as the second housing part and the third housing part move from the unfolded state to a folded state.

According to an embodiment of the present disclosure, provided is a foldable electronic apparatus including: a first housing part; a second housing part; a flexible display accommodated in the first housing part or the second housing part; and a hinge assembly rotatably connecting the first housing part and the second housing part to each other. The hinge assembly may include: a first fixing bracket including a first rotation guide groove and a second rotation guide groove; a first rotating arm rotating around a first rotation axis in linkage with the first rotation guide groove of the first fixing bracket, connected to the first housing part, and having a first accommodating part provided therein; a second rotating arm rotating around a second rotation axis in linkage with a second slide groove of the first fixing bracket, connected to the second housing part, and having a second accommodating part provided therein; a first support plate including a first connection part at least partially accommodated in the first accommodating part, and rotating around a third rotation axis included in the first connection part; and a second support plate including a second connection part at least partially accommodated in the second accommodating part, and rotating around a fourth rotation axis included in the second connection part. The first support plate and the second support plate may support a portion of the flexible display if the first housing part and the second housing part are in a fully unfolded state. The first rotation axis may be a virtual rotation axis serving as a rotational center of the first rotating arm, and the second rotation axis may be a virtual rotation axis serving as a rotational center of the second rotating arm.

According to an embodiment of the present disclosure, provided is a foldable electronic apparatus comprising: a foldable housing configured to include a first housing part and a second housing part; a first hinge structure comprising a hinge assembly configured to rotatably connect the first housing part and the second housing part to each other; and a flexible display disposed across the first housing part and the second housing part; wherein the hinge assembly includes: a first fixing bracket; a first rotating arm having one end rotatably connected to a first side of the first fixing bracket and the other end fixed to the first housing part; a second rotating arm having one end rotatably connected to a second side of the first fixing bracket and the other end fixed to the second housing part; a first support plate rotatably connected to the first rotating arm; and a second support plate rotatably connected to the second rotating arm; and wherein the first support plate and the second support plate are configured to: support the flexible display in an unfolded state where the first housing part and the second housing part are unfolded; and be spaced apart from each other in linkage with rotation of the first housing part and the second housing part as the first housing part and the second housing part move from the unfolded state to a folded state where the first housing part and the second housing part are folded.

[Brief Description of Drawings]

In describing the drawings, the same or similar components are denoted by the same or similar reference numerals.

FIG. 1 is a view showing an example of a first state of an electronic apparatus according to an embodiment of the present disclosure.

FIG. 2 is a view showing an example of a second state of the electronic apparatus according to an embodiment of the present disclosure.

FIG. 3 is a view showing an example of a third state of the electronic apparatus according to an embodiment of the present disclosure.

FIG. 4 is a plan view showing the electronic apparatus according to an embodiment of the present disclosure without a flexible display according to an embodiment of the present disclosure.

FIG. 5 is a rear view showing the electronic apparatus according to an embodiment of the present disclosure without the rear cover and display of each of first, second, and third housing parts.

FIG. 6A is an assembly view showing a second hinge structure of the electronic apparatus according to an embodiment of the present disclosure.

FIG. 6B is an exploded view showing the second hinge structure of the electronic apparatus according to an embodiment of the present disclosure.

FIG. 7 is a plan view showing a first hinge assembly of the second hinge structure according to an embodiment of the present disclosure.

FIG. 8 is a view showing an example in which the second housing part and the third housing part are connected to each other by using the first hinge assembly of the second hinge structure according to an embodiment of the present disclosure.

FIG. 9 is a view showing a fixing bracket of the first hinge assembly according to an embodiment of the present disclosure.

FIG. 10 is a partial exploded view showing the first hinge assembly according to an embodiment of the present disclosure.

FIG. 11 is a view showing an example in which first and second rotating arms of the first hinge assembly according to an embodiment of the present disclosure rotate between a first position and a second position.

FIG. 12 is a partial exploded view showing the first hinge assembly according to an embodiment of the present disclosure.

FIG. 13 is a view showing a first support plate of the first hinge assembly according to an embodiment of the present disclosure.

FIG. 14 is a view showing a part of the first rotating arm of the first hinge assembly according to an embodiment of the present disclosure.

FIGS. 15 and 16 are views showing the first support plate of the first hinge assembly according to an embodiment of the present disclosure.

FIG. 17 is an exploded view showing a structure for connecting first and second support plates to the first and second rotating arms of the first hinge assembly according to an embodiment of the present disclosure.

FIG. 18 is a view showing the first hinge assembly according to an embodiment of the present disclosure, and is a cross-sectional view taken along lines D-D' and E-E' shown in FIG. 7.

FIG. 19 is an assembly view showing the first and second support plates of the first hinge assembly coupled to the first and second rotating arms by using first and second anti-separation caps according to an embodiment of the present disclosure.

FIG. 20 is a view showing the first hinge assembly according to an embodiment of the present disclosure, and is a cross-sectional view taken along line G-G' shown in FIG. 19.

FIG. 21 is a view showing the first hinge assembly according to an embodiment of the present disclosure, and is a cross-sectional view taken along line H-H' shown in FIG. 19.

FIG. 22 is a view showing an example of the flexible display of the electronic apparatus that is spaced apart from the first and second support plates according to an embodiment of the present disclosure.

FIG. 23 is a view showing a positional relationship between a bendable part of the flexible display and the first and second support plates in case that the first hinge assembly is operated according to an embodiment of the present disclosure.

FIGS. 24A, 24B, and 24C are views showing the operation of the first hinge assembly according to an embodiment of the present disclosure.

FIGS. 25A, 25B, and 25C are views showing the first support plates and second support plates of the first hinge assembly according to an embodiment of the present disclosure.

FIGS. 26A and 26B are views showing the first support plates and second support plates of the first hinge assembly according to an embodiment of the present disclosure.

FIG. 27 is a view showing an example in which the anti-separation cap of the first hinge assembly according to an embodiment of the present disclosure is attached to the first housing part by using an adhesive member.

FIG. 28A is a view showing an example in which a slit groove is formed to fix the anti-separation cap of the first hinge assembly according to an embodiment of the present disclosure to the first housing part by welding.

FIG. 28B is a view showing an example in which a welded portion is formed in the slit groove shown in FIG. 28A.

FIG. 29 is a view showing a fixing bracket according to an embodiment of the present disclosure.

FIG. 30 is a view showing a second hinge cover according to an embodiment of the present disclosure.

FIG. 31 is a view showing a first hinge assembly coupled to the second hinge cover according to an embodiment of the present disclosure.

FIG. 32 is a view showing an example of front ends of the first and second support plates in contact with a contact protrusion of the second hinge cover of the electronic apparatus according to an embodiment, and is a cross-sectional view taken along line M-M' shown in FIG. 30.

FIGS. 33 and 34 are views showing the first support plate and second support plate according to an embodiment of the present disclosure.

FIGS. 35 and 36 are views showing an example in which each of first and second support plates of a first hinge assembly includes a segmented structure according to an embodiment.

[Mode for the Invention]

The present disclosure may be variously modified and have several embodiments, and specific embodiments of the present disclosure are thus illustrated in the accompanying drawings and described in detail in the detailed description. However, it should be understood that the scope of the present disclosure is not limited to the specific embodiments, and includes various modifications, equivalents and/or alternatives according to at least one embodiment of the present disclosure. Throughout the accompanying drawings, similar components are denoted by similar reference numerals.

In describing the present disclosure, omitted is a detailed description of a case where it is decided that a detailed description of the known functions or configurations related to the present disclosure may unnecessarily obscure the gist of the present disclosure. In addition, at least one embodiment of the present disclosure may be modified in several different forms, and the scope and spirit of the present disclosure are not limited to the following embodiments. Rather, these embodiments make the present disclosure thorough and complete, and are provided to completely convey the spirit of the present disclosure to those skilled in the art.

Terms used in the present disclosure are used only to describe the specific embodiments rather than limit the scope of the present disclosure. A term of a singular number may include its plural number unless explicitly indicated otherwise in the context.

In the present disclosure, the expression "have", "may have", "include", "may include" or the like, indicates the presence of a corresponding feature (e.g., a numerical value, a function, an operation, or a component such as a part), and does not exclude the presence of an additional feature.

In the present disclosure, the expression "A or B", "least one of A and/or B" or "one or more of A and/or B" or the like may include all possible combinations of items enumerated together. For example, "A or B", "at least one of A and B", or "at least one of A or B" may indicate all of 1) a case in which at least one A is included, 2) a case in which at least one B is included, or 3) a case in which both of at least one A and at least one B are included.

The expressions "first", "second", and the like used in the present disclosure may indicate various components regardless of the sequence and/or importance of the components. These expressions are only used to distinguish one component and another component from each other, and do not limit the corresponding components. Among the expressions used in the present disclosure, "front end" may be referred to as "first end", and "rear end" may be referred to as "second end".

An expression "configured (or set) to" used in the present disclosure may be replaced by an expression "suitable for", "having the capacity to", "designed to", "adapted to", "made to" or "capable of" based on a context. The expression "configured (or set) to" may not necessarily indicate "specifically designed to" in hardware.

In the present disclosure, a "module" or a "part" may perform at least one function or operation, and be implemented by hardware or software or be implemented by a combination of hardware and software. In addition, a plurality of "modules" or a plurality of "parts" may be integrated in at least one module and be implemented by at least one processor except for a "module" or a "part" that needs to be implemented by specific hardware.

Meanwhile, the various elements and regions in the drawings are schematically shown. Therefore, the spirit of the present disclosure is not limited by relative sizes or intervals shown in the accompanying drawings.

Hereinafter, the embodiments of the present disclosure are described in detail with reference to the accompanying drawings so that those skilled in the art to which the present disclosure pertains may easily practice the present disclosure.

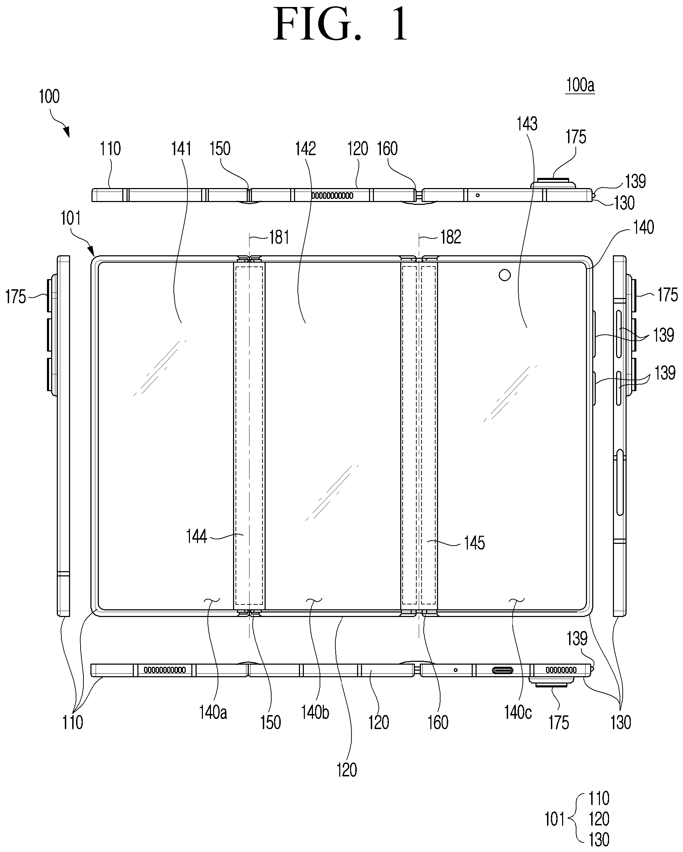

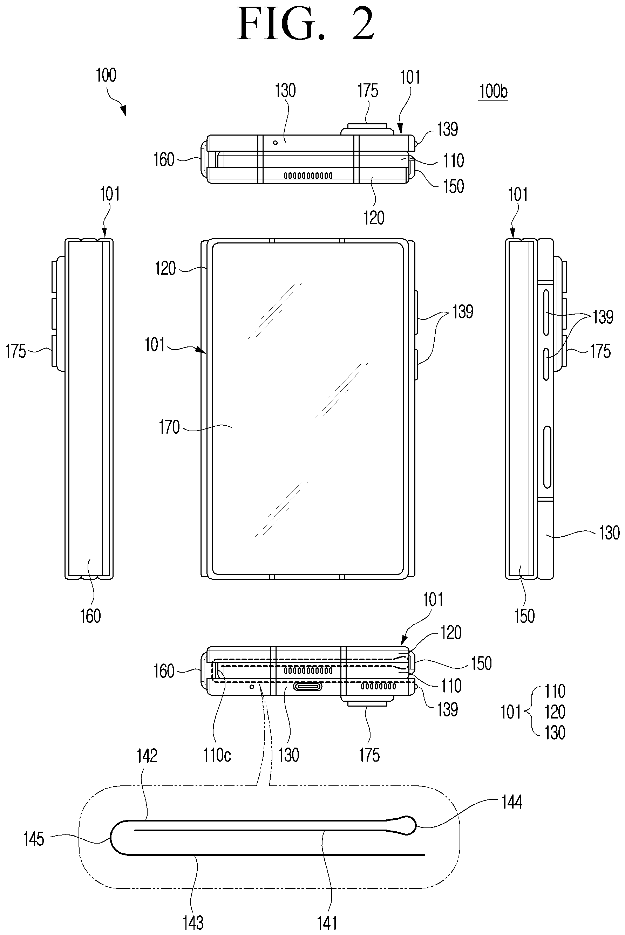

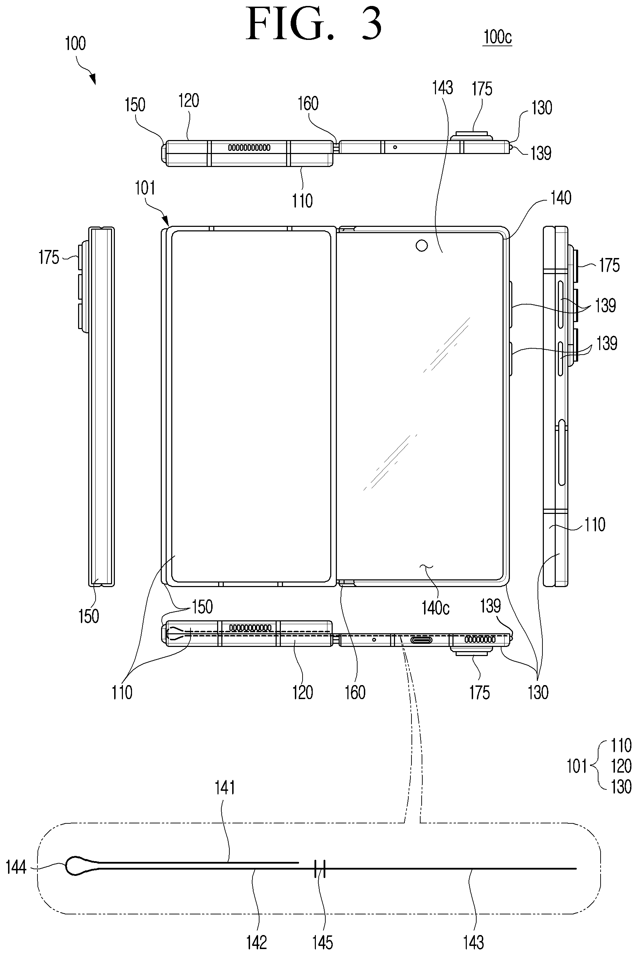

FIG. 1 is a view showing an example of a first state of an electronic apparatus according to an embodiment of the present disclosure. FIG. 2 is a view showing an example of a second state of the electronic apparatus according to an embodiment of the present disclosure. FIG. 3 is a view showing an example of a third state of the electronic apparatus according to an embodiment of the present disclosure.

Referring to FIGS. 1, 2, and 3, an electronic apparatus 100 may include a housing structure 101, a flexible display 140, a first hinge structure 150, a second hinge structure 160, and a display 170. The housing structure 101 may include a first housing part 110, a second housing part 120, and a third housing part 130. In the present disclosure, the housing structure 101 may be referred to as a 'foldable housing' and may be given the same reference numeral 101.

The first housing part 110 may be rotatably coupled to the second housing part 120 by the first hinge structure 150. The second housing part 120 and the first housing part 110 may rotate around the first hinge structure 150. While the first housing part 110 rotates with respect to the first hinge structure 150, the second housing part 120 may rotates with respect to the first hinge structure 150. For example, if the second housing part 120 and the first housing part 110 rotate around the first hinge structure 150, an angular displacement of the second housing part 120 may be substantially equal to an angular displacement of the first housing part 110.

The third housing part 130 may be rotatably coupled to the second housing part 120 by the second hinge structure 160. The second housing part 120 and the third housing part 130 may rotate around the second hinge structure 160. While the second housing part 120 rotates with respect to the second hinge structure 160, the third housing part 130 may rotate around the second hinge structure 160. For example, if the second housing part 120 and the third housing part 130 rotate around the second hinge structure 160, the angular displacement (or angular change) of the second housing part 120 may be substantially equal to an angular displacement of the third housing part 130.

The first hinge structure 150 and the second hinge structure 160 may change a state of the electronic apparatus. The first hinge structure 150 and the second hinge structure 160 may provide (or enable) a first state 100a of the electronic apparatus 100 (or the first state 100a of the housing structure 101). The first state 100a of the electronic apparatus 100 (or the first state 100a of the housing structure 101) may be described as an unfolded state (or unfolding state) of the electronic apparatus 100 (or the housing structure 101). In the first state 100a, a front surface of the first housing part 110, a front surface of the second housing part 120, and a front surface of the third housing part 130 may define a front surface of the electronic apparatus 100. In the first state 100a, the front surface of the first housing part 110, the front surface of the second housing part 120, and the front surface of the third housing part 130 may face the same direction. In the first state 100a, the electronic apparatus 100 may provide a user with a large display region of the flexible display 140. In the present disclosure, the 'front' (or 'upper') surface of each of the first housing part 110, a second housing part 120, and a third housing part 130 may be considered to be the surface on which the flexible display 140 is disposed.

The first hinge structure 150 and the second hinge structure 160 may provide a second state 100b of the electronic apparatus 100 (or the second state 100b of the housing structure 101). The second state 100b of the electronic apparatus 100 (or the second state 100b of the housing structure 101) may be described as a folded state (or a folding state or multi-folding state) of the electronic apparatus 100 (or the housing structure 101). In the second state 100b, the front surface of the first housing part 110 and the front surface of the second housing part 120 may face opposite directions, and the front surface of the second housing part 120 and the front surface of the third housing part 130 may face opposite directions. In the second state 100b, the front surface of the first housing part 110 and the front surface of the third housing part 130 may face the same direction. For example, in the second state 100b, the front surface of the second housing part 120 may face the front surface of the first housing part 110, and the front surface of the third housing part 130 may face a rear surface of the first housing part 110. In the second state 100b, a rear surface of the second housing part 120 may be exposed to the outside. The display 170 may be disposed on the rear surface of the second housing part 120. In the second state 100b, a rear surface of the third housing part 130 may be exposed to the outside. A camera 175 may be disposed on the rear surface of the third housing part 130. In the second state 100b, the electronic apparatus 100 may be folded to improve portability and provide visual information through the display 170 disposed on the rear surface of the second housing part 120.

The electronic apparatus 100 may further include a key button 139. The key button 139 may be exposed through a structure (e.g., an opening) formed in a side surface of the third housing part 130 and may partially protrude to the outside of the electronic apparatus 100. The key button 139 may provide a physical input to a processing circuit inside the electronic apparatus 100 by a pressure transmitted from the outside. The key button 139 may not be included in the electronic apparatus 100 and may be implemented in another form, such as a soft key displayed on the flexible display 140 or the display 170.

The key button 139 may be disposed on the side surface of the third housing part 130 to be exposed to the outside in the second state 100b. As the key button 139 is disposed on the side surface of the third housing part 130, the key button 139 may be disposed in a direction in which the side surface of the third housing part 130 faces. Even if the second state 100b is changed to the first state 100a by the user viewing the display 170, a position of the key button 139 disposed on the side surface of the third housing part 130 may not move. For example, referring to FIG. 1, in the first state 100a, in case of viewing the flexible display 140 from above, the key button 139 may be disposed on a right side. Referring to FIG. 2, in the second state 100b, in case of viewing the display 170 from above, the key button 139 may be disposed on the right side.

The first hinge structure 150 and the second hinge structure 160 may provide a third state 100c of the electronic apparatus 100. The third state 100c of the electronic apparatus 100 may be described as a partially folded and partially unfolded state (or a single-folded state or a half-folded state) of the electronic apparatus 100. For example, in the third state 100c, the front surface of the second housing part 120 and the front surface of the third housing part 130 may face the same direction, and the front surface of the first housing part 110 and the front surface of the second housing part 120 may face the opposite directions. For example, in the third state 100c, the first housing part 110 and the second housing part 120 may be folded, and the second housing part 120 and the third housing part 130 may be unfolded. In the third state 100c, the electronic apparatus 100 may provide the visual information through a portion of the flexible display 140 (e.g., third display region 140c).

The electronic apparatus 100 may change from the first state 100a to the second state 100b via the third state 100c. The electronic apparatus 100 may change from the first state 100a, which is the unfolded state, to the third state 100c, which is the partially unfolded state. For example, the electronic apparatus 100 may change from the first state 100a, in which the first housing part 110, the second housing part 120, and the third housing part 130 face the same direction, to the third state 100c, in which the front surface of the first housing part 110 faces the front surface of the second housing part 120. The electronic apparatus 100 may change from the third state 100c, which is the partially unfolded state, to the second state 100b, which is the folded state. For example, in case of changing from the third state 100c to the second state 100b, the folded first and second housing part 110 and 120 may be disposed on the third housing part 130.

The flexible display 140 may at least partially define an exterior appearance of the electronic apparatus 100. The flexible display 140 may be partially disposed within the housing structure 101. The flexible display 140 may define the front surface of the electronic apparatus 100. The flexible display 140 may include a first part 141, a second part 142, a third part 143, a first bending part 144, and a second bending part 145. For example, the first part 141, second part 142, and third part 143 may be unbendable (e.g. rigid or substantially rigid) portions of the flexible display 140. For example, the first part 141, second part 142, and third part 143 may be bendable (i.e. flexible) portions of the display that remain (or are intended to remain) unbent (i.e. flat) or substantially unbent during normal use of the electronic apparatus 100 (which may include folding and unfolding). The first bending part 144 and second bending part 145 may be bendable portions of the flexible display 140 that bend (or are intended to bend) during folding and unfolding of the electronic apparatus 100. The first part 141 of the flexible display 140 may be disposed on the front surface of the first housing part 110. The second part 142 of the flexible display 140 may be disposed on the front surface of the second housing part 120. The third part 143 of the flexible display 140 may be disposed on the front surface of the third housing part 130. The first bending part 144 of the flexible display 140 may be disposed between the first and third bending parts 141 and 143 of the flexible display 140. For example, the first bending part 144 of the flexible display 140 may be disposed on the first hinge structure 150 connecting the first housing part 110 to the second housing part 120. The second bending part 145 of the flexible display 140 may be disposed between the second and third parts 142 and 143 of the flexible display 140. For example, the second bending part 145 of the flexible display 140 may be disposed on the second hinge structure 160 connecting the second housing part 120 to the third housing part 130.

The first hinge structure 150 and the second hinge structure 160 may allow the first part 141 of the flexible display 140, the second part 142 of the flexible display 140, and the third part 143 of the flexible display 140 to face substantially the same direction. In the first state 100a, the first bending part 144 and the second bending part 145 may be disposed on substantially the same horizontal plane as the first part 141, the second part 142, and the third part 143.

The first hinge structure 150 and the second hinge structure 160 may provide the second state 100b of the electronic apparatus 100. In the second state 100b, the second part 142 of the flexible display 140 may face the first part 141 of the flexible display 140, and the third part 143 of the flexible display 140 may face the rear surface of the first housing part 110.

In the second state 100b, the first bending part 144 of the flexible display 140 may be bent by the first hinge structure 150, and the first bending part 144 of the flexible display 140 may thus be folded to allow the first part 141 of the flexible display 140 and the second part 142 of the flexible display 140 to face different directions.

In the second state 100b, the second bending part 145 of the flexible display 140 may be bent by the second hinge structure 160, and the second bending part 145 of the flexible display 140 may thus be folded to allow the second part 142 of the flexible display 140 and the third part 143 of the flexible display 140 to face different directions. In the second state 100b, the first housing part 110 may be disposed between the second housing part 120 and the third housing part 130. In the second state 100b, the second bending part 145 of the flexible display 140 that is disposed on the second hinge structure 160 may partially face a side surface 110c of the first housing part 110.

The first hinge structure 150 and the second hinge structure 160 may provide the third state 100c of the electronic apparatus 100. In the third state 100c, the first part 141 of the flexible display 140 may face the second part 142 of the flexible display 140, and the third part 143 of the flexible display 140 may face the same direction as the second part 142 of the flexible display 140. For example, the second part 142 and the third part 143 may be disposed on substantially the same horizontal plane.

In the third state 100c, the first bending part 144 of the flexible display 140 may be bent by the first hinge structure 150, and the first bending part 144 of the flexible display 140 may thus be folded to allow the first part 141 of the flexible display 140 and the second part 142 of the flexible display 140 to face different directions.

In the third state 100c, the second bending part 145 of the flexible display 140 may be maintained in the unfolded state by the second hinge structure 160, and the second bending part 145 of the flexible display 140 may thus be unfolded to allow the second part 142 of the flexible display 140 and the third part 143 of the flexible display 140 to face the same direction.

The display region of the flexible display 140 may include a first display region 140a, a second display region 140b, and the third display region 140c. The display region represents a region that may provide the visual information from the flexible display 140. In the first state 100a, the entire display region of the flexible display 140 may be visible from the front surface of the housing structure 101. For example, in the first state 100a, the first display region 140a, second display region 140b, and third display region 140c of the flexible display 140 may be visually exposed. The electronic apparatus 100 may provide the user with the large display region including the first display region 140a, the second display region 140b, and the third display region 140c.

In the second state 100b, the display region of the flexible display 140 may not be visible. For example, in the second state 100b, the first display region 140a, second display region 140b, and third display region 140c of the flexible display 140 may not be visually exposed.

In the third state 100c, the display region of the flexible display 140 may be partially visible from the front surface of the third housing part 130. For example, the third display region 140c may be visually exposed, and the first display region 140a and the second display region 140b may not be visually exposed.

As a non-restricted example, in the first state 100a of the electronic apparatus 100, if the flexible display 140 is used to display a screen, the first display region 140a, second display region 140b, and third display region 140c of the flexible display 140 may be activated. As a non-restricted example, in the second state 100b, the first display region 140a, second display region 140b, and third display region 140c of the flexible display 140 may be deactivated. As a non-restricted example, in the third state 100c of the electronic apparatus 100, if the flexible display 140 is used to display the screen, the third display region 140c may be activated and the first display region 140a and second display region 140b of the flexible display 140 may be deactivated.

As a non-restricted example, in the first state 100a of the electronic apparatus 100, if the flexible display 140 is used to display the screen, the first display region 140a, second display region 140b, and third display region 140c of the flexible display 140 may display the visual information. As a non-restricted example, in the second state 100b, the first display region 140a, second display region 140b, and third display region 140c of the flexible display 140 may provide a black image. As a non-restricted example, in the third state 100c of the electronic apparatus 100, if the flexible display 140 is used to display the screen, the third display region 140c may provide the visual information, and the first display region 140a and second display region 140b of the flexible display 140 may provide the black image.

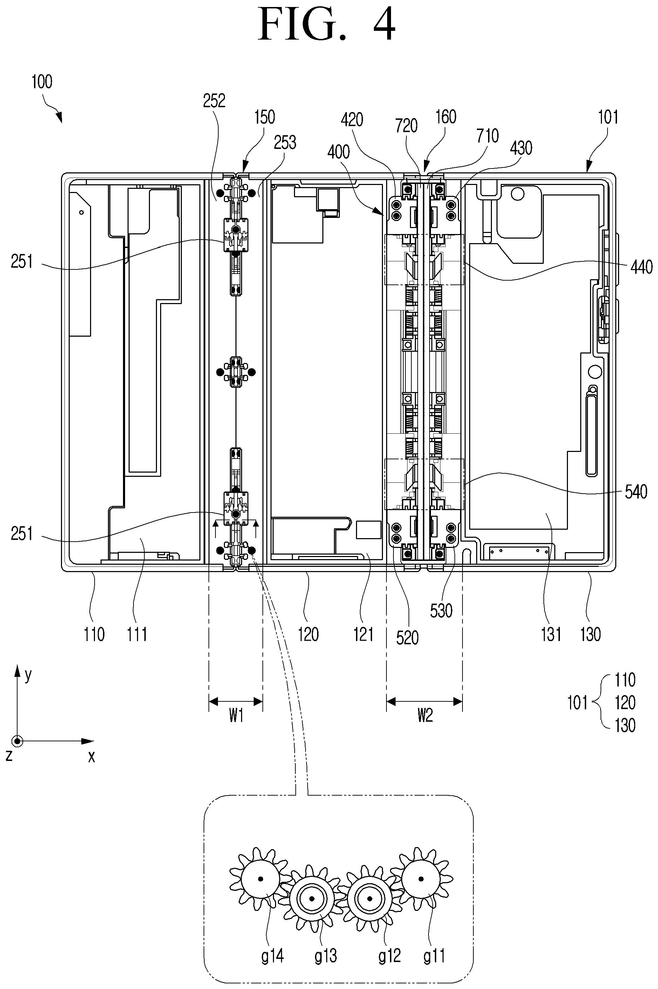

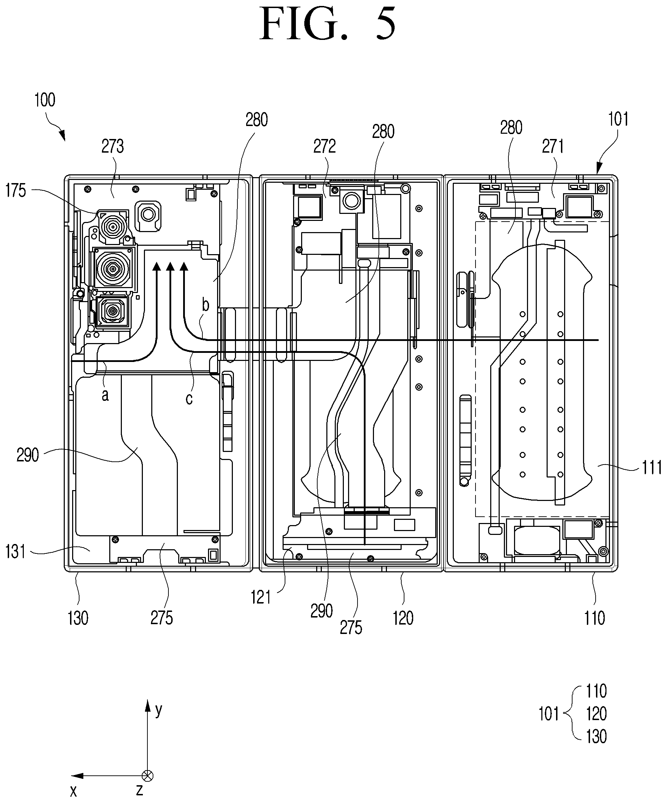

FIG. 4 is a plan view showing the electronic apparatus 100 according to an embodiment of the present disclosure without the flexible display 140 according to an embodiment of the present disclosure. FIG. 5 is a rear view showing the electronic apparatus 100 according to an embodiment of the present disclosure without the rear cover and display 170 of each of the first, second, and third housing parts 110, 120, and 130. In the present disclosure, the x-axis, y-axis, and z-axis may be as shown in FIG. 4 and FIG. 5. The y-axis direction may be defined as the direction parallel to the folding (or rotation) axis of the first hinge structure 150 and/or the second hinge structure 160. The x-axis direction may be defined as the direction perpendicular to the folding axis (i.e. the y-axis) and parallel to the surface of the flexible display 140 in the first state 100a (or parallel to the front surfaces of the first, second, and/or third housing parts 110, 120, 130 in the first state 100a, or parallel to the first and second rotating arms 420 and 430 when the angle between the first and second rotating arms 420 and 430 is 180 degrees). The z-axis direction may be defined as the direction perpendicular to the folding axis (i.e. the y-axis) and the x-axis. The z-axis direction may be defined as the direction perpendicular to the surface of the of the flexible display 140 in the first state 100a, or perpendicular to the first and second rotating arms 420 and 430 when the angle between the first and second rotating arms 420 and 430 is 180 degrees.

Referring to FIGS. 4 and 5, the electronic apparatus 100 may include the first hinge structure 150 and the second hinge structure 160. A first width w1 of the first hinge structure 150 may be narrower than a second width w2 of the second hinge structure 160. A difference between the first width w1 of the first hinge structure 150 and the second width w2 of the second hinge structure 160 may be equal to or greater than a thickness of the first housing part 110. For example, the second hinge structure 160 may have the second width w2 that is wider than the first width w1 to allow the first housing part 110 to be disposed between the second housing part 120 and the third housing part 130 in the second state 100b. The first hinge structure 150 may be referred to as a narrow hinge structure because the first hinge structure 150 has a narrower width than the second hinge structure 160. The second hinge structure 160 may be referred to as a wide hinge structure because second hinge structure 160 has a wider width than the first hinge structure 150.

The first hinge structure 150 may have a first dimension, which is a distance between rotation axes of the first housing part 110 and the second housing part 120, and the second hinge structure 160 may have a second dimension, which is a distance between the rotation axes of the second housing part 120 and the third housing part 130 and greater than the first dimension. In this way, by comparing the dimensions between the rotation axes, the first hinge structure 150 may be referred to as the narrow hinge structure and the second hinge structure 160 may be referred to as the wide hinge structure, respectively.

The first hinge structure 150 may include a first gear set 251, a first hinge plate 252, and a second hinge plate 253. The first hinge structure 150 may have a rear surface covered by a first hinge cover 151 (see FIG. 2). The first hinge cover 151 may be disposed between the rear covers that cover the rear surfaces of the first housing part 110 and the second housing part 120, respectively.

The first hinge plate 252 may be coupled to a first support part 111 of the first housing part 110. A second hinge plate 254 may be coupled to a second support part 121 of the second housing part 120. Gears g11, g12, g13, and g14 included in the first gear set 251 may rotate the first hinge plate 252 and the second hinge plate 253. For example, the gears g11, g12, g13, and g14 included in the first gear set 251 may rotate the first hinge plate 252 (or the second housing part 120) in linkage with the rotation of the first hinge plate 252 (or the first housing part 110). After the rotation of the first hinge plate 252 (or the first housing part 110), the gears g11, g12, g13, and g14 included in the first gear set 251 may rotate based on the rotation of the first hinge plate 252 (or the first housing part 110). The second hinge plate 253 (or the second housing part 120) may rotate in linkage with the rotation of the first hinge plate 252 based on the rotation of the gears included in the first gear set 251. The gears g11, g12, g13, and g14 included in the first gear set 251 may include the first gear g11, the second gear g12, the third gear g13, and the fourth gear g14. The first gear g11 may be disposed adjacent to the first hinge plate 252, and the fourth gear g14 may be disposed adjacent to the second hinge plate 253. The second gear g12 and the third gear g13 may be disposed between the first gear g11 and the fourth gear g14. The first gear g11, the second gear g12, the third gear g13, and the fourth gear g14 may be sequentially engaged. Based on the rotation of the first gear g11 in a first rotation direction (e.g., clockwise), the second gear g12 engaged with the first gear g11 may rotate in a second rotation direction (e.g., counterclockwise) opposite to the first rotation direction. Based on the rotation of the second gear g12 in the second rotation direction, the third gear g13 engaged with the second gear g12 may rotate in the first rotation direction. Based on the rotation of the third gear g13 in the first rotation direction, the fourth gear g14 may rotate in the second rotation direction. As the first gear g11 and the fourth gear g14 rotate in different directions, the first housing part 110 connected to the first hinge plate 252 and the second housing part 120 connected to the second hinge plate 253 may be folded or unfolded.

The second hinge structure 160 may include a first hinge assembly 400 and a second hinge assembly 500, a first support plate 710, and a second support plate 720. The second hinge structure 160 may have a rear surface covered by a second hinge cover 161 (see FIG. 2). The second hinge cover 161 may be disposed between the rear covers that cover the rear surfaces of the second housing part 120 and the third housing part 130, respectively.

The first hinge assembly 400 and the second hinge assembly 500 may be symmetrically disposed to each other. The first hinge assembly 400 may have one side coupled to the second housing part 120 and the other side coupled to the third housing part 130. For example, a first rotating arm 420 of the first hinge assembly 400 may be coupled to the second housing part 120 (for example, the first rotating arm 420 may be coupled to a second support part 121 of the second housing part 120), and a second rotating arm 430 of the first hinge assembly 400 may be coupled to the third housing part 130 (for example, the second rotating arm 430 may be coupled to a third support part 131 of the third housing part 130). The second hinge assembly 500 may have one side coupled to the second housing part 120 and the other side coupled to the third housing part 130. For example, a first rotating arm 520 of the second hinge assembly 500 may be coupled to the second housing part 120 (for example, the first rotating arm 520 may be coupled to the second support part 121 of the second housing part 120), and a second rotating arm 530 of the second hinge assembly 500 may be coupled to the third housing part 130 (for example, the second rotating arm 530 may be coupled to the third support part 131 of the third housing part 130).

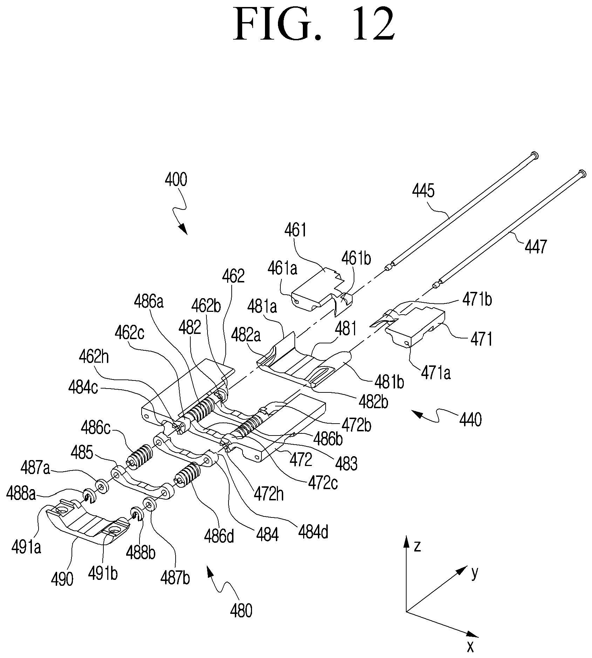

The first hinge assembly 400 and the second hinge assembly 500 may include synchronization structures 440 and 540 to synchronize the rotations of the second housing part 120 and the third housing part 130 to each other. The synchronization structure 440 of the first hinge assembly 400 may include a spiral groove formed in first, second, third, and fourth linkage arms 461, 462, 471 and 472 (see FIG. 12) that are linked with rotations of first and second rotating arms 420 and 430 of the first hinge assembly 400, and a slider 481 (see FIG. 12) that slides along the spiral groove. The synchronization structure 540 of the second hinge assembly 500 may be substantially the same as the synchronization structure 440 of the first hinge assembly 400. The second housing part 120 and the third housing part 130 may rotate at substantially the same angular displacement through the first rotating arm 420 and second rotating arm 430 of the first hinge assembly 400 and the synchronization structure 440 of the first hinge assembly 400. The first rotating arm 520 and second rotating arm 530 of the second hinge assembly 500 may rotate at substantially the same angular displacement through the synchronization structure 540 of the second hinge assembly 500. For example, the first rotating arm 420 of the first hinge assembly 400 and the first rotating arm 520 of the second hinge assembly 500 may rotate together with the second housing part 120 in the same direction as a rotation direction of the second housing part 120. The second rotating arm 430 of the first hinge assembly 400 and the second rotating arm 530 of the second hinge assembly 500 may rotate together with the third housing part 130 in the same direction as a rotation direction of the third housing part 130.

The electronic apparatus 100 may include a first printed circuit board 271, a second printed circuit board 272, and a third printed circuit board 273. The first printed circuit board 271 may be disposed on the first support part 111 of the first housing part 110. A hardware component in the first housing part 110 may be mounted on the first printed circuit board 271. The second printed circuit board 272 may be disposed on the second support part 121 of the second housing part 120. The third printed circuit board 273 may be disposed on the third support part 131 of the third housing part 130. A hardware component in the third housing part 130 may be mounted on the third printed circuit board 273.

The hardware component disposed on the first printed circuit board 271 may support a hardware component disposed on the second printed circuit board 272 and/or the hardware component disposed on the third printed circuit board 273 or be operated independently thereof.

The hardware component disposed on the second printed circuit board 272 may support the hardware component disposed on the first printed circuit board 271 or the third printed circuit board 273 or be operated independently thereof. The hardware component disposed on the second printed circuit board 272 may include a speaker, a front camera, and/or display driving circuitry.

The hardware component disposed on the third printed circuit board 273 may include at least one processor including a processing circuit (e.g., an application processor (AP) or a communication processor (CP)), a memory including at least one storage medium, a communication circuit, and a rear camera 175. The rear camera 175 may be exposed through a structure (e.g., an opening) in the rear surface of the second housing part 120.

The electronic apparatus 100 may further include a sub-printed circuit board 275 and flexible printed circuit boards 280 and 290. The sub-printed circuit board 275 may be disposed in at least some of the first housing part 110, the second housing part 120, and the third housing part 130. The flexible printed circuit boards 280 and 290 may include the first flexible printed circuit board 280 and the second flexible printed circuit board 290. The first flexible printed circuit board 280 may electrically connect the printed circuit boards disposed in the housing parts 110, 120, and 130 to one another. The second flexible printed circuit board 290 may connect the sub-printed circuit board 275 to a printed circuit board in the housing part in which the sub-printed circuit board 275 is disposed.

Components in the electronic apparatus 100 may be connected to at least one processor in the third printed circuit board 273 by using the flexible printed circuit boards 280 and 290. For example, a signal received from an antenna disposed in the third housing part 130 may be transmitted to the third printed circuit board 273, in which at least one processor (e.g., AP or CP) is disposed, through a signal path "a" provided by the first flexible printed circuit board 280. A driving circuit for the flexible display 140 disposed in the first housing part 110 may be connected to the third printed circuit board 273, in which at least one processor (e.g., AP) is disposed, through a signal path "b" provided by the sub-printed circuit board 275 or the first flexible printed circuit board 280. A driving circuit for the display 170 that is connected to the sub-printed circuit board 275 disposed in the second housing part 130 may be electrically connected to the third printed circuit board 273, in which at least one processor (e.g., AP) is disposed, through a signal path "c" provided by the sub-printed circuit board 275, the first flexible printed circuit board 280, or the second flexible printed circuit board 290.

The electronic apparatus 100 may further include batteries. The batteries may be attached to support parts 111, 121, and 131 included in the housing parts 110, 120, and 130, respectively. The support parts 111, 121, and 131 may support rechargeable batteries.

An arrangement of the hardware components is exemplary, and unlike the description above, the rear camera 175 and the second printed circuit board 272 may be disposed in the third housing part 130, and the third printed circuit board 273 may be disposed in the second housing part 120.

The first housing part 110 and the third housing part 130 are shown as rotating in the opposite directions with respect to the second housing part 120, and are not limited thereto. For example, during the change from the first state 100a to the second state 100b, the first housing part 110 may rotate counterclockwise with respect to the second housing part 120, and the third housing part 130 may rotate counterclockwise with respect to the second housing part 120. As the first housing part 110 and the third housing part 130 rotate in the same direction, a portion of the display region of the flexible display 140 in the second state 100b may be visually exposed.

The second hinge structure 160 according to an embodiment may include two or more hinge assemblies depending on a vertical length of the electronic apparatus 100 (e.g., a length in a y-axis direction in FIG. 4). For example, the second hinge structure 160 may include two hinge assemblies (e.g., the first hinge assembly 400 and the second hinge assembly 500) as shown in FIG. 4. However, the second hinge structure 160 may include more than two hinge assemblies. For example, if a vertical length of the electronic apparatus 100 is longer than the vertical length of the electronic apparatus 100 shown in FIG. 4, the second hinge structure 160 may include three or more hinge assemblies.

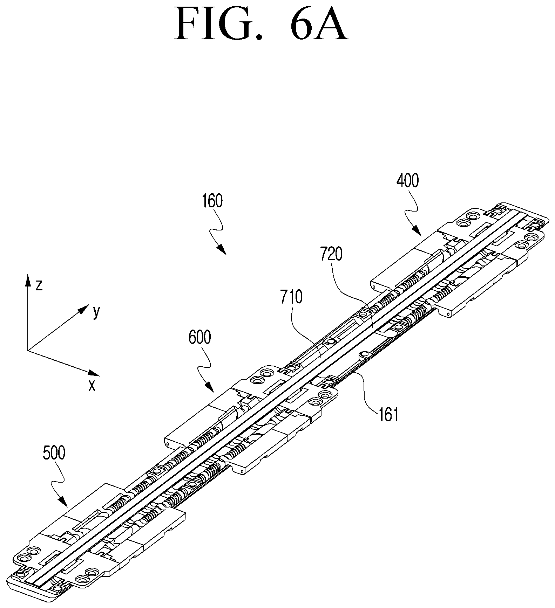

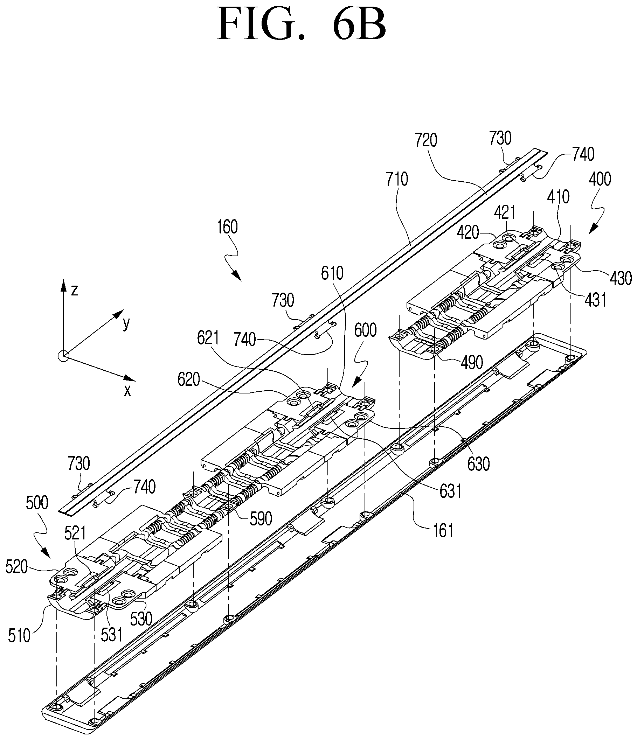

FIG. 6A is an assembly view showing the second hinge structure 160 of the electronic apparatus 100 according to an embodiment of the present disclosure. FIG. 6B is an exploded view showing the second hinge structure 160 of the electronic apparatus 100 according to an embodiment of the present disclosure.

Referring to FIGS. 6A and 6B, the second hinge structure 160 may include the second hinge cover 161, the first hinge assembly 400, the second hinge assembly 500, a third hinge assembly 600, the first support plate 710, and the second support plate 720.

The first hinge assembly 400, the second hinge assembly 500, and the third hinge assembly 600 may be disposed at the second hinge cover 161. The first hinge assembly 400 and the second hinge assembly 500 may be disposed at one side and the other side of the second hinge cover 161, respectively. For example, the first hinge assembly 400 may be disposed at (or near) one end of the second hinge cover 161 and the second hinge assembly 500 may be disposed at (or near) the other end of the second hinge cover 161. The first hinge assembly 400 and the second hinge assembly 500 may be symmetrically disposed to each other. The third hinge assembly 600 may be disposed between the first hinge assembly 400 and the second hinge assembly 500.

The first hinge assembly 400, the second hinge assembly 500, and the third hinge assembly 600 may be fixed to the second hinge cover 161. For example, the first hinge assembly 400 may include a fixing bracket 410 and a fixing block 490. The fixing bracket 410 and the fixing block 490 may be disposed at a predetermined interval along the length direction of the first hinge assembly 400. The fixing bracket 410 and fixing block 490 of the first hinge assembly 400 may be fixed to the second hinge cover 161 by using a plurality of fastening screws, respectively. However, the present disclosure is not limited thereto, and it will be appreciated that the fixing bracket 410 and fixing block 490 of the first hinge assembly 400 may be fixed to the second hinge cover 161 by any suitable fixing means, for example by using an adhesive.

The second hinge assembly 500 may be substantially identical to the first hinge assembly 400. The fixing bracket 510 and fixing block 590 of the second hinge assembly 500 may be fixed to the second hinge cover 161 by using a plurality of fastening screws, respectively. However, the present disclosure is not limited thereto, and it will be appreciated that the fixing bracket 510 and fixing block 590 of the second hinge assembly 500 may be fixed to the second hinge cover 161 by any suitable fixing means, for example by using an adhesive.

The third hinge assembly 600 may be substantially identical or similar to the first and the second hinge assembly 400. The third hinge assembly 600 may share the fixing block 590 of the second hinge assembly 500. The third hinge assembly 600 may be connected to the second hinge assembly 500 by using the fixing block 590 of the second hinge assembly 500. A fixing bracket 610 of the third hinge assembly 600 may be fixed to the second hinge cover 161 by using a plurality of fastening screws. However, the present disclosure is not limited thereto, and it will be appreciated that the fixing bracket 610 of the third hinge assembly 600 may be fixed to the second hinge cover 161 by any suitable fixing means, for example by using an adhesive.

In this specification, if the second housing part 120 and the third housing part 130 are in the first state 100a (see FIG. 1) and the third state 100c (see FIG. 3), the second housing part 120 and the third housing part 130 may be described to be at a "first position." For example, the "first position" may be a position in which the second housing part 120 and the third housing part 130 are unfolded such that the second housing part 120 and the third housing part 130 are disposed on the same plane (i.e. the angle between them is 180 degrees or substantially 180 degrees). If the second housing part 120 and the third housing part 130 are in the second state 100b, the second housing part 120 and the third housing part 130 may be described to be at a "second position." The "second position" may therefore be a position in which the second housing part 120 and the third housing part 130 are folded together (i.e. such that the angle between them is 0 degrees or substantially 0 degrees).

The first support plate 710 and the second support plate 720 may be rotatably connected to the first, second, and third hinge assemblies 400, 500, and 600. The first support plate 710 and the second support plate 720 may support the flexible display 140 if the second housing part 120 and the third housing part 130 are at the first position. The first support plate 710 and the second support plate 720 may be spaced apart from the flexible display 140 (for example by a predetermined gap) while the second housing part 120 and the third housing part 130 move out of the first position and into the second position. The first support plate 710 and the second support plate 720 may be spaced apart from the flexible display 140 by the predetermined gap while maintaining the second position. For example, the electronic apparatus 100 may be configured such that the first support plate 710 and the second support plate 720 only support (or contact) the flexible display 140 when the second housing part 120 and the third housing part 130 are at the first position. For example, the electronic apparatus 100 may be configured such that the first support plate 710 and the second support plate 720 do not support (or contact) the flexible display 140 when the second housing part 120 and the third housing part 130 are at the second position, or are at an (or any) intermediate position between the first position and the second position.

The first support plate 710 and the second support plate 720 may not be in contact with the flexible display 140 at a position other than the first position. The flexible display 140 may not be damaged by the first support plate 710 and the second support plate 720 due to an external impact applied to the electronic apparatus 100 at the position other than the first position. Here, the "external impact" may refer to an impact that occurs if the electronic apparatus 100 hits a surrounding object or a structure or falls from a predetermined height and crashes into the ground. Because the first support plate 710 and the second support plate 720 are spaced apart from the flexible display 140 in positions other than the first (i.e. unfolded) position, the flexible display 140 is less likely to be damaged by contact with the first support plate 710 and the second support plate 720 in case of external impact.

The first support plate 710 may include a plurality of first connection parts 730 extending from one side of the first support plate 710 (e.g., a left side of the first support plate 730 in FIG. 6B) at predetermined intervals. The plurality of first connection parts 730 may be rotatably connected to first accommodating parts 421, 521, and 621 provided in the first rotating arms 420, 520, and 620 of the first, second, and third hinge assemblies 400, 500, and 600, respectively. A plurality of second connection parts 740 may be rotatably connected to second accommodating parts 431, 531, and 631 provided in the second rotating arms 430, 530, and 630 of the first, second and third hinge assemblies 400, 500, and 600, respectively.

The first support plate 710 and the second support plate 720 may each include a material that is durable, heat-resistant, and lightweight. For example, the first support plate 710 and the second support plate 720 may each include a metal material (e.g., stainless steel, alloy steel, aluminum, titanium, or magnesium) or a synthetic resin (e.g., polyetheretherketone (PEEK), polyamide (PA), polyoxymethylene (POM), polycarbonate (PC), polyphenylene sulfide (PPS), or polysulfone (PSU)).

Hereinafter, the configuration and operation of the first hinge assembly 400 are described with reference to the drawings. Although the electronic apparatus 100 has been described above as including two or more hinge assemblies, it will be appreciated that the electronic apparatus 100 may comprise just a single hinge assembly (e.g. first hinge assembly 400) or may include a plurality of hinge assemblies of various configurations, wherein only one (or only some) of the plurality of hinge assemblies is configured as described in the present disclosure (e.g. first hinge assembly 400).

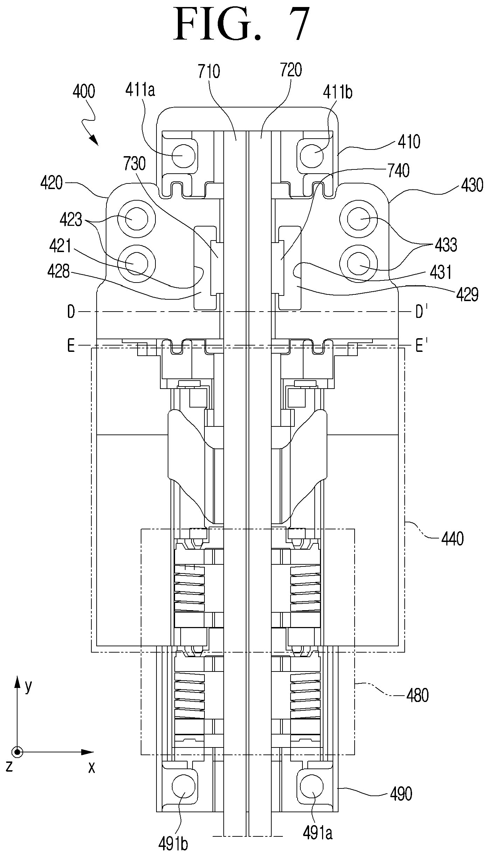

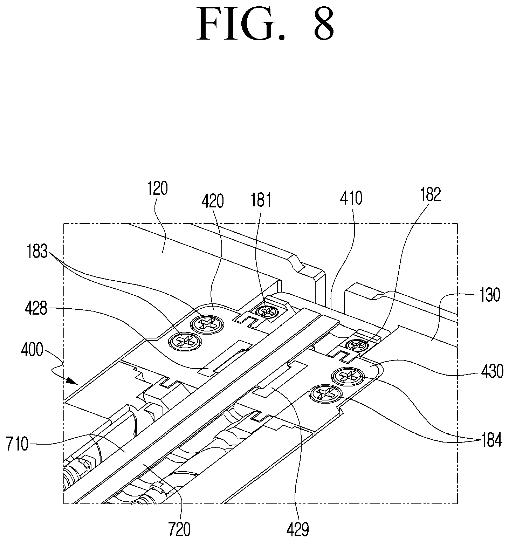

FIG. 7 is a plan view showing a first hinge assembly 400 of the second hinge structure 160 (see FIG. 6B) according to an embodiment of the present disclosure. Referring to FIG. 7, the first hinge assembly 400 may include the fixing bracket 410, the first rotating arm 420, the second rotating arm 430, the synchronization structure 440, a free stop structure 480, the fixing block 490, the first support plate 710, and the second support plate 720. The fixing bracket 410 and the fixing block 490 may form one end and the other end of the first hinge assembly 400, respectively, and may be fixed to the second hinge cover 161 (see FIG. 6B). For example, the fixing bracket 410 and the fixing block 490 may be fixed to the second hinge cover 161 by using a plurality of fastening screws 181 and 182 (see FIG. 8). The fixing bracket 410 may include a plurality of first fastening holes 411a and 411b to which the plurality of fastening screws 181 and 182 are coupled, and the fixing block 490 may include a plurality of second fastening holes 491a and 491b to which the plurality of fastening screws are coupled. For example, the fixing bracket 410 and the fixing block 490 may be fixed to the second hinge cover 161 by ultrasonic welding.

The first rotating arm 420 and the second rotating arm 430 may be symmetrically disposed to each other relative to a virtual center line along the length direction of the first hinge assembly 400 (e.g., a y-axis direction in FIG. 7, or a direction parallel to the folding axis of the first hinge assembly 400). The first rotating arm 420 may be fixed to the second housing part 120, and the second rotating arm 430 may be fixed to the third housing part 130. For example, the first rotating arm 420 may be fixed to the second housing part 120 by using the plurality of fastening screws 183 (see FIG. 8), and the second rotating arm 430 may be fixed to the third housing part 130 by using the plurality of fastening screws 183. The first rotating arm 420 may include a plurality of third fastening holes 423 to which a plurality of fastening screws 184 (see FIG. 8) are coupled, and the second rotating arm 430 may include a plurality of fourth fastening holes 433 to which the plurality of fastening screws 184 are coupled. The first rotating arm 420 may rotate clockwise or counterclockwise together with the second housing part 120, and the second rotating arm 430 may rotate clockwise or counterclockwise together with the third housing part 130.

The first accommodating part 421 into which the first connection part 730 extending from the first support plate 710 is rotatably inserted may be provided in the upper surface of the first rotating arm 420. A first anti-separation cap 428 may be coupled to the first accommodating part 421 to prevent the first connection part 730 extending from the first support plate 710 inserted thereinto from being separated. For example, the first anti-separation cap 428 may provide a function of securing the first connection part 730 in the first accommodating part 421 to prevent the first connection part 730 from separating from the first accommodating part 421. The second accommodating part 431, into which the second connection part 740 extending from the second support plate 720 is rotatably inserted, may be provided in the upper surface of the second rotating arm 430. A second anti-separation cap 438 may be coupled to the second accommodating part 431 to prevent the second connection part 740 extending from the second support plate 720 inserted thereinto from being separated. For example, the second anti-separation cap 438 may provide a function of securing the second connection part 740 in the second accommodating part 431 to prevent the second connection part 740 from separating from the second accommodating part 431.

The synchronization structure 440 may be connected to the first rotating arm 420 and the second rotating arm 430 to allow the first rotating arm 420 and the second rotating arm 430 to simultaneously rotate in opposite directions and at the same angle. For example, the first rotating arm 420 and the second rotating arm 430 may use the synchronization structure 440 to rotate the second housing part 120 and the third housing part 130 at the same angle in an unfolding direction or rotate the second housing part 120 and the third housing part 130 at the same angle in a folding direction.

The free stop structure 480 may be connected between the synchronization structure 440 and the fixing block 490. For example, the free stop structure 480 may have one end connected to the synchronization structure 440 and the other end connected to the fixing block 490. The free stop structure 480 may stop and be fixed at a corresponding position if the second housing part 120 and the third housing part 130 are unfolded or folded at a specific angle. The free stop structure 480 may open and maintain the screen at an angle desired by the user.

The first support plate 710 may be rotatably connected to the first rotating arm 420 by using the first connection part 730. The second support plate 720 may be rotatably connected to the second rotating arm 430 by using the second connection part 740.

At the first position (see the first state 100a in FIG. 1 or the third state 100 in FIG. 3), the first rotating arm 420 and the second rotating arm 430 may be disposed on substantially the same plane and may be spaced apart from each other by a predetermined gap. The first support plate 710 and the second support plate 720 may cover the gap between the first rotating arm 420 and the second rotating arm 430 to support the second bending part 145 (see FIG. 3) of the flexible display 140. The first position may be a fully unfolded position, at which the second housing part 120 and the third housing part 130 in FIGS. 1 and 3 are disposed on substantially the same plane.

At the second position, the first rotating arm 420 and the second rotating arm 430 may rotate from the first position by about 90 degrees to be disposed substantially parallel to each other. The first support plate 710 and the second support plate 720 may retract toward the second hinge cover 161 to be spaced apart from the second bending part 145 of the flexible display 140, which protrudes toward the second hinge cover 161 (see FIG. 6B) in linkage with the first rotating arm 420 and the second rotating arm 430. The second position may be a fully folded position at which the second housing part 120 and the third housing part 130 in FIG. 2 rotate from the first position (e.g., zero degrees) by about 90 degrees to be disposed substantially parallel to each other. For example, the second position may be a fully folded position at which the second housing part 120 and the third housing part 130 in FIG. 2 each rotate from their respective positions in the first position by about 90 degrees to be disposed substantially parallel to each other.

FIG. 8 is a view showing an example in which the second housing part 120 and the third housing part 130 are connected to each other by using the first hinge assembly 400 of the second hinge structure 160 according to an embodiment of the present disclosure

Referring to FIG. 8, the fixing bracket 410 of the first hinge assembly 400 may be fixed to an inner surface of the second hinge cover 161 (see FIG. 6B) by using the plurality of fastening screws 181 and 182. The first rotating arm 420 may have one end rotatably coupled to a left side of the fixing bracket 410 and the other end fixed to the second housing part 120 by the plurality of fastening screws 183. The second rotating arm 430 may have one end rotatably coupled to a right side of the fixing bracket 410 and the other end fixed to the third housing part 130 by using the plurality of fastening screws 184.

The first support plate 710 may be rotatably connected to the first rotating arm 420 by using the first connection part 730. The first connection part 730 may not be separated from the first accommodating part 421 by using the first anti-separation cap 428 coupled to the first accommodating part 421 of the first rotating arm 420. The second support plate 720 may be rotatably connected to the second rotating arm 430 by using the second connection part 740. The second connection part 740 may not be separated from the second accommodating part 431 by using the second anti-separation cap 429 coupled to the second accommodating part 431 of the second rotating arm 430.

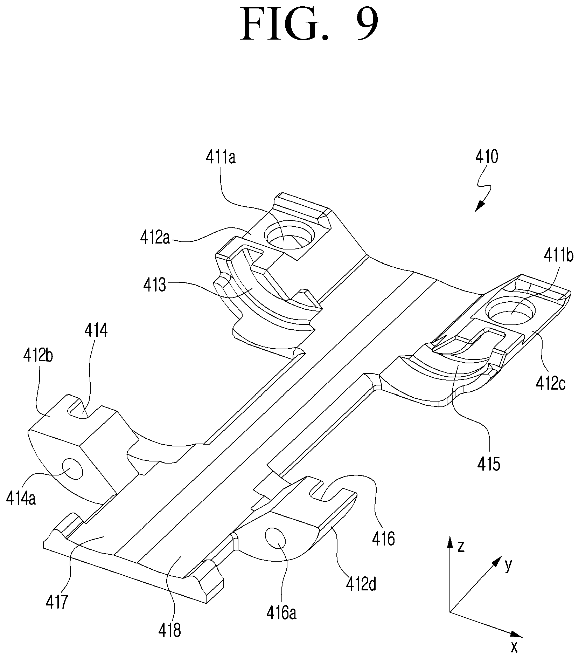

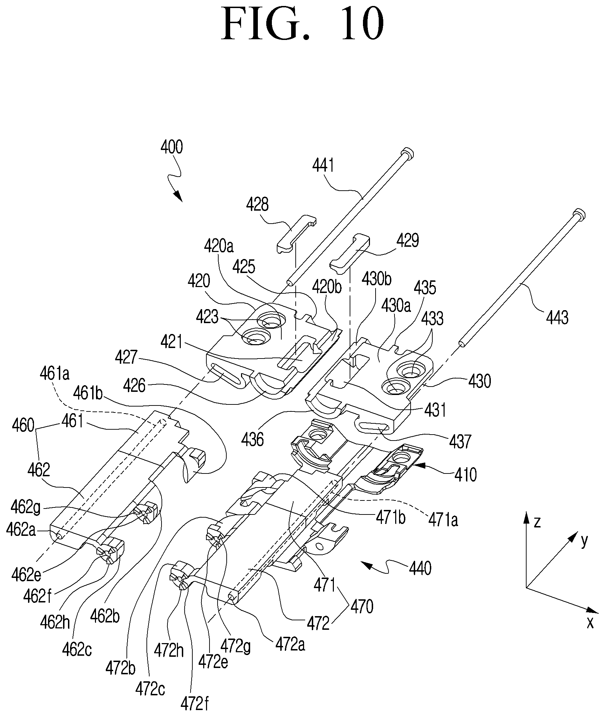

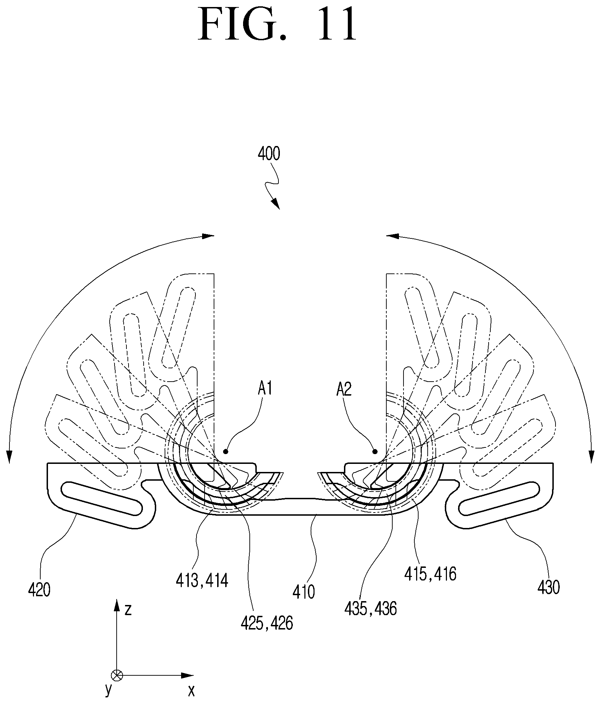

FIG. 9 is a view showing the fixing bracket 410 of the first hinge assembly 400 according to an embodiment of the present disclosure. FIG. 10 is a partial exploded view showing the first hinge assembly 400 according to an embodiment of the present disclosure. FIG. 11 is a view showing an example in which the first and second rotating arms 420 and 430 of the first hinge assembly 400 according to an embodiment of the present disclosure rotate between the first position and the second position. FIG. 12 is a partial exploded view showing the first hinge assembly 400 according to an embodiment of the present disclosure.

The description describes the fixing bracket 410, the first rotating arm 420, the second rotating arm 430, the synchronization structure 440, and the free stop structure 480 included in the first hinge assembly 400 with reference to FIGS. 9, 10, 11 and 12.

The fixing bracket 410 may include a first rotational supporter 412a and a second rotational supporter 412b disposed on the first side of the fixing bracket 410 (e.g., the left side of the fixing bracket 410 shown in FIG. 9) and spaced apart from each other, and include a third rotational supporter 412c and a fourth supporter 412d disposed on the second side of the fixing bracket 410 (e.g., the right side of the fixing bracket 410 shown in FIG. 9) and spaced apart from each other. The first rotational supporter 412a and the third rotational supporter 412c may be symmetrically disposed relative to the virtual center line along the length direction of the fixing bracket 410 (e.g., a y-axis direction in FIG. 9). The second rotational supporter 412b and the fourth rotational supporter 412d may be symmetrically disposed relative to the virtual center line along the length direction of the fixing bracket 410.

The first rotation supporter 412a and the second rotation supporter 412b may rotatably support the first rotating arm 420. For example, the first rotation supporter 412a may include a first rotation guide groove 413 into which a first rotation rail 425 of the first rotating arm 420 is slidably inserted. The second rotation supporter 412b may include a second rotation guide groove 414 into which a second rotation rail 426 of the first rotating arm 420 is slidably inserted. The first rotation guide groove 413 may have an arc shape having a predetermined curvature centered on a first rotation axis A1. The second rotation guide groove 414 may be disposed to face the first rotation guide groove 413. The second rotation guide groove 414 may have an arc shape having substantially the same curvature as the first rotation guide groove 413 centered on the first rotation axis A1.

The third rotation supporter 412c and the fourth rotation supporter 412d may rotatably support the second rotating arm 430. For example, the third rotation supporter 412c may include a third rotation guide groove 415 into which a third rotation rail 435 of the second rotating arm 430 is slidably inserted. The fourth rotation supporter 412d may include a fourth rotation guide groove 416 into which a fourth rotation rail 436 of the second rotating arm 430 is slidably inserted. The third rotation guide groove 415 may be formed as an arc shape having a predetermined curvature centered on a second rotation axis A2. The fourth rotation guide groove 416 may be disposed to face the third rotation guide groove 415. The fourth rotation guide groove 416 may have an arc shape having substantially the same curvature as the third rotation guide groove 415 centered on the second rotation axis A2.

The first rotation supporter 412a and the third rotation supporter 412c may include the plurality of first fastening holes 411a and 411b. The second rotation supporter 412b may include a first through hole 414a into which a first shaft 445 is inserted, and the fourth rotation supporter 412d may include a second through hole 416a into which a second shaft 447 is inserted. The first through hole 414a and the second through hole 416a may each be disposed to be parallel to a center line of the fixing bracket 410. The first shaft 445 may be a rotational center of a first part 460 of the synchronization structure 440, and the second shaft 447 may be a rotational center of a second part 470 of the synchronization structure 440.

The first rotating arm 420 may include the first and second rotation rails 425 and 426 slidably inserted into the first and second rotation guide grooves 413 and 414 of the fixing bracket 410, respectively. The second rotating arm 430 may include the third and fourth rotation rails 435 and 436 slidably inserted into the third and fourth rotation guide grooves 415 and 416 of the fixing bracket 410, respectively.

The first rotating arm 430 may rotate clockwise and counterclockwise around the first rotation axis A1. For example, a rotation angle range of the first rotating arm 420 from the first position (e.g., an angle parallel to an x-axis direction in FIG. 11) to the second position may be about zero to 90 degrees. The second rotating arm 430 may have substantially the same rotation angle range as the first rotating arm 420 from the first position to the second position by using the synchronization structure 440. The second rotating arm 430 may simultaneously rotate with the rotation of the first rotating arm 420 in a direction opposite to the rotation direction of the first rotating arm 420 as shown in FIG. 11 by using the synchronization structure 440.

The first rotating arm 420 may be connected to the first part 460 of the synchronization structure 440 by using a first connection pin 441. The first rotating arm 420 may include a first elongated hole 427 through which the first connection pin 441 passes. The first elongated hole 427 may be disposed to be inclined downward from one side of the first rotating arm 420 (e.g., a left side of the first rotating arm 420 in FIG. 10) toward the other side of the first rotating arm 420 (e.g., a right side of the first rotating arm 420 in FIG. 10). The first connection pin 441 may transmit a rotational motion of the first rotating arm 420 to the first part 460 of the synchronization structure 440. The first part 460 of the synchronization structure 440 may rotate in substantially the same direction as the first rotating arm 420 around the first shaft 445.

The first rotating arm 420 may include a first support surface 420b disposed adjacent to the second rotating arm 430 and supporting the first support plate 710. The first support plate 710 may be seated on the first support surface 420b of the first rotating arm 420 at the first position. The first support surface 420b may have a height difference (e.g. relative to the z-axis in FIG. 10) from an upper surface 420a of the first rotating arm 420. For example, the first support surface 420b may be disposed at a lower position (relative to the z-axis in FIG. 10) than the upper surface 420a of the first rotating arm 420.

The second rotating arm 430 may be connected to the second part 470 of the synchronization structure 440 by using a second connection pin 443. The second rotating arm 430 may include a second elongated hole 437 through which the second connection pin 443 passes. The second elongated hole 437 may be disposed to be inclined downward from one side of the second rotating arm 430 (e.g., a right side of the second rotating arm 430 in FIG. 10) toward the other side of the second rotating arm 430 (e.g., a left side of the second rotating arm 430 in FIG. 10). The second connection pin 443 may transmit a rotational motion of the second rotating arm 430 to the second part 470 of the synchronization structure 440. The second part 470 of the synchronization structure 440 may rotate in substantially the same direction as the second rotating arm 430 around the second shaft 447.

The second rotating arm 430 may include a second support surface 430b disposed adjacent to the first rotating arm 420 and supporting the second support plate 720. The second support plate 720 may be seated on the second support surface 430b of the second rotating arm 430 at the first position. The second support surface 430b may have a height difference (e.g. relative to the z-axis in FIG. 10) from an upper surface 430a of the second rotating arm 430. For example, the second support surface 430b may be disposed at a lower position (relative to the z-axis in FIG. 10) than the upper surface 430a of the second rotating arm 430.

The first part 460 of the synchronization structure 440 may include the first linkage arm 461 and the second linkage arm 462. The first linkage arm 461 and the second linkage arm 462 may have separate configurations. The first linkage arm 461 may include a first insertion hole 461a into which the first connection pin 441 is inserted, and the second linkage arm 462 may include a second insertion hole 462a into which the first connection pin 441 is inserted. The first connection pin 441 may be sequentially inserted into the first elongated hole 427 of the first rotating arm 420, the first insertion hole 461a of the first linkage arm 461, and the second insertion hole 462a of the second linkage arm 462. The first linkage arm 461 and then the second linkage arm 462 may be disposed in a row along the length direction (e.g., a y-axis direction in FIG. 10) by using the first connection pin 441.

If the first rotating arm 420 rotates from the first position to the second position or from the second position to the first position, the first connection pin 441 may slide along the first elongated hole 427 and transmit a rotational force of the first rotating arm 420 to the first linkage arm 461 and the second linkage arm 462. The first linkage arm 461 and the second linkage arm 462 may rotate around the first shaft 445 together with the first rotating arm 420.

The second part 470 of the synchronization structure 440 may include the third linkage arm 471 and the fourth linkage arm 472. The third linkage arm 471 and the fourth linkage arm 472 may have separate configurations. The third linkage arm 471 may include a third insertion hole 471a into which the second connection pin 443 is inserted, and the fourth linkage arm 472 may include a fourth insertion hole 472a into which the second connection pin 443 is inserted. The second connection pin 443 may be sequentially inserted into the second elongated hole 437 of the second rotating arm 430, the third insertion hole 471a of the third linkage arm 471, and then the fourth insertion hole 472a of the fourth linkage arm 472. The third linkage arm 471 and the fourth linkage arm 472 may be disposed in a row along the length direction (e.g., the y-axis direction in FIG. 10) by using the second connection pin 443.

If the second rotating arm 430 rotates from the first position to the second position or from the second position to the first position, the second connection pin 443 may slide along the second elongated hole 437 and transmit a rotational force of the second rotating arm 430 to the third linkage arm 471 and the fourth linkage arm 472. The third linkage arm 471 and the fourth linkage arm 472 may rotate around the second shaft 447 together with the second rotating arm 430.

The slider 481 may include a first spiral coupling part 481a disposed on one side and a second spiral coupling part 481b on the other side. The first spiral coupling part 481a of the slider 481 may be slidably coupled between a first spiral guide 461b of the first linkage arm 461 and a second spiral guide 4621b of the second linkage arm 462. The first spiral coupling part 481a may include a first through hole 481a through which the first shaft 445 passes. The second spiral coupling part 481b of the slider 481 may be slidably coupled between a third spiral guide 471b of the third linkage arm 471 and a fourth spiral guide 4721b of the fourth linkage arm 472. The second spiral coupling part 481b may include a second through hole 482b through which the second shaft 447 passes.

The slider 481 may synchronize rotation of the first or second linkage arm 461 or 462 of the synchronization structure 440 with rotation of the third or fourth linkage arm 471 or 472 included in the second part 470 of the synchronization structure 440. For example, if the first rotating arm 420 rotates from the first position to the second position, the first and second linkage arms 461 and 462 of the synchronization structure 440 may rotate from the first position to the second position. The slider 481 may transmit a rotational force of the first or second linkage arm 461 or 462 of the synchronization structure 440 to the third or fourth linkage arm 471 or 472 of the synchronization structure 440. Accordingly, the third or fourth linkage arm 471 or 472 of the synchronization structure 440 may rotate in a direction opposite to the rotation direction of the first or second linkage arm 461 or 462 of the synchronization structure 440.

The slider 481 may transmit the rotational force of the first or second linkage arm 461 or 462 of the synchronization structure 440 to the third or fourth linkage arm 471 or 472 of the synchronization structure 440, or conversely transmit the rotational force of the third or fourth linkage arm 471 or 472 of the synchronization structure 440 to the first or second linkage arm 461 or 462 of the synchronization structure 440, while moving forward or backward along the first or second shaft 445 or 447 in a linear direction (e.g., the y-axis direction in FIG. 10).

The free stop structure 480 may be disposed along the length direction of the first hinge assembly 400 (e.g., a y-axis direction in FIG. 12). The free stop structure 480 may have a front end (e.g., it can be called 'first end') disposed between the second linkage arm 462 and the fourth linkage arm 472 and a rear end (e.g., it can be called 'second end') supported by the fixing block 490. The free stop structure 480 may include a first cam member 482, a second cam member 484, a first axis bracket 483, a second axis bracket 485, and first, second, third, and fourth resilient members 486a, 486b, 486c, and 486d. For example, the first, second, third, and fourth resilient members 486a, 486b, 486c, and 486d may be coil springs.

The first cam member 482, the first and second resilient members 486a and 486b, and the first axis bracket 483 may be disposed between the second linkage arm 462 and the fourth linkage arm 472. First cam structures (e.g., a plurality of cam protrusions, not shown) may be provided on both sides of a front end surface of the first cam member 482. Second cam structures (e.g., a plurality of cam protrusions, not shown), which are cam-connected to the first cam structures of the first cam member 482, may be provided on a rear end surface of the second spiral guide 462b and a rear end surface of the fourth spiral guide 472b, respectively. The first and second resilient members 486a and 486b may be resiliently disposed between the first cam member 482 and the first axis bracket 483. The first axis bracket 483 may be resiliently supported by a protruding part 462c of the second linkage arm 462 and a protruding part 472c of the fourth linkage arm 472 by elastic forces of the first and second resilient members 486a and 486b.

The second cam member 484, the third and fourth resilient members 486c and 486d, and the second axis bracket 485 may be disposed between the protruding part 462c of the second linkage arm 462, the protruding part 472c of the fourth linkage arm 472, and the fixing block 490.

Third cam structures (e.g., a plurality of cam protrusions) 484d may be provided on both sides of a front end surface of the second cam member 484. Fourth cam structures (e.g., a plurality of cam protrusions) 462h and 472h, which are connected to the third cam structures 484d, may be provided on a rear end surface of the protruding part 462c of the second linkage arm 462 and a rear end surface of the protruding part 472c of the fourth linkage arm 472, respectively. The third and fourth resilient members 486c and 486d may be resiliently disposed between the second cam member 484 and the second axis bracket 485. The second axis bracket 485 may be resiliently supported toward the fixing block 490 by elastic forces of the third and fourth resilient members 486c and 486d.

The first shaft 445 may be screwed into a groove (not shown) provided in a front end surface of the fixing block 490 by passing through one side of the free stop structure 480. The second shaft 447 may be screwed into a groove (not shown) provided in the front end surface of the fixing block 490 by passing through the other side of the free stop structure 480. Washers 487a and 487b and U-rings 488a and 488b respectively coupled to the first shaft 445 and the second shaft 447 may be disposed between the second axis bracket 485 and the fixing block 490.

While the second linkage arm 462 and the fourth linkage arm 472 rotate from the first position to the second position, the first cam member 482 and the second cam member 484 may move back toward the fixing block 490. In this case, as the elastic forces of the first and second resilient members 486a and 486b increases, a frictional force between the first cam structure of the first cam member 482 and the second cam structure cam-connected to the first cam structure may increase. As the elastic forces of the third and fourth resilient members 486c and 486d increases, a frictional force between the third cam structure 484c of the second cam member 484 and the fourth cam structure 462h or 472h cam-connected to the third cam structure 484c or 484d may increase. Accordingly, the second housing part 120 and the third housing part 130 may have a torque increased by the free stop structure 480 of the first hinge assembly 400 while rotating from the first position to the second position. Accordingly, the second housing part 120 and the third housing part 130 may be stopped at the specific angle.

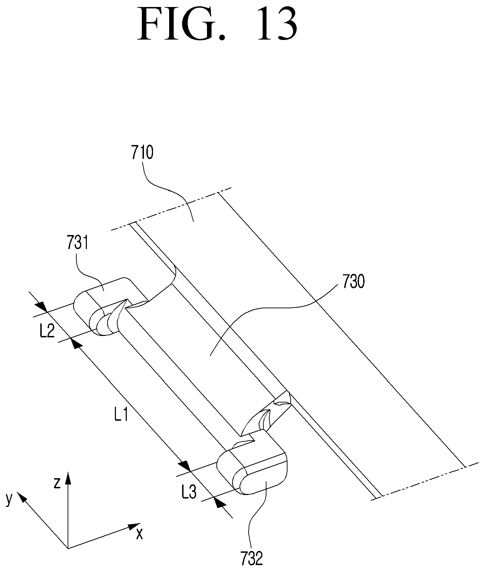

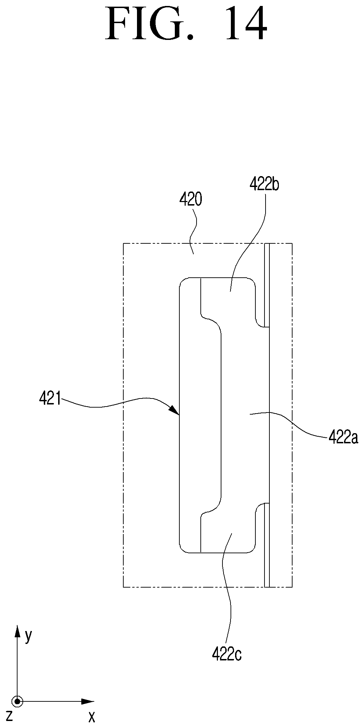

FIG. 13 is a view showing the first support plate 710 of the first hinge assembly 400 according to an embodiment of the present disclosure. FIG. 14 is a view showing the first accommodating part 421 of the first rotating arm 420 of the first hinge assembly 400 according to an embodiment of the present disclosure.

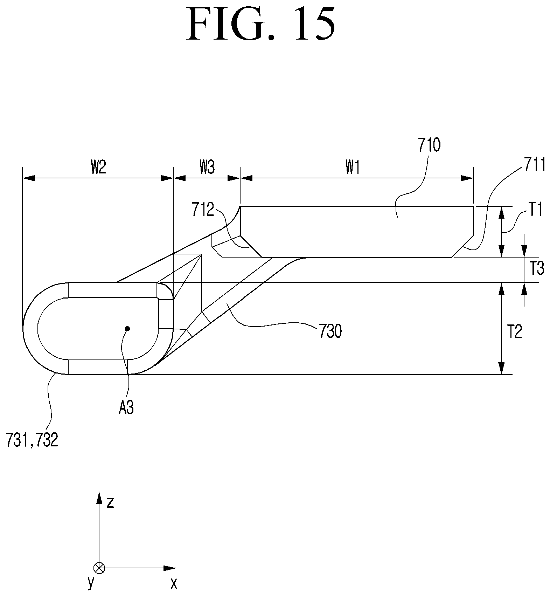

Referring to FIGS. 13 and 14, the first support plate 710 may be rotatably connected to the first rotating arm 420 by using the first connection part 730 extending from one side of the first support plate 710. The first connection part 730 extending from the first support plate 710 may have a first rotating protrusion 731 and a second rotating protrusion 732. For example, the first rotating protrusion 731 and the second rotating protrusion 732 may be provided at both ends along the length direction (e.g., a y-axis direction in FIG. 13). For example, the first rotating protrusion 731 may be provided at one end (in the y-axis direction) of the first connection part 730 and the second rotating protrusion 732 may be provided at the other end (in the y-axis direction) of the first connection part 730. The first rotating protrusion 731 and the second rotating protrusion 732 may protrude from both the ends of the first connection part 730 by a predetermined length in a direction away from the first support plate 710 (e.g., an x-axis direction in FIG. 13). The first rotating protrusion 731 and the second rotating protrusion 732 may be symmetrically formed with each other. For example, each of the first rotating protrusion 731 and the second rotating protrusion 732 may have a round shape having a predetermined curvature at a lower left side, an upper left side, and a lower right side, as shown in FIG. 15. In this case, each of the round shapes of the first rotating protrusion 731 and the second rotating protrusion 732 may have the same curvature.

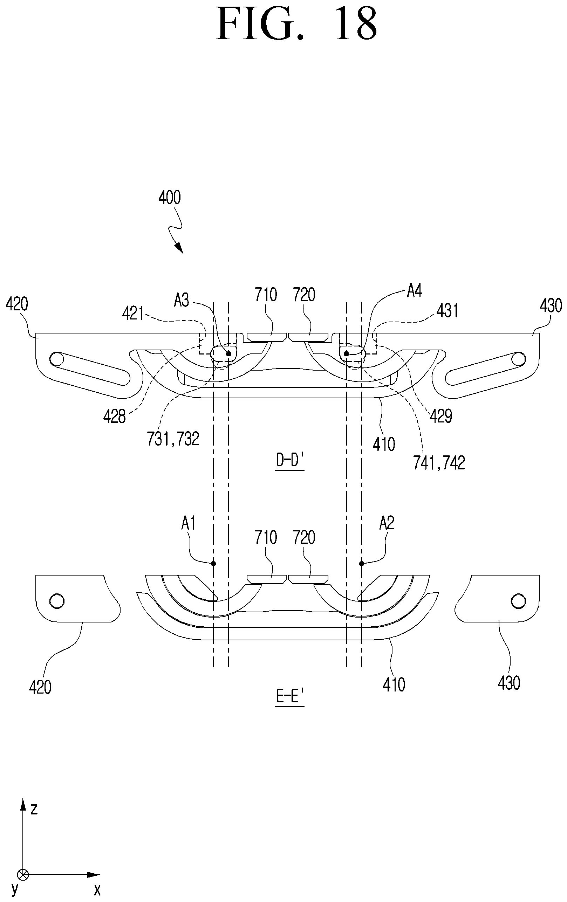

The first rotating protrusion 731 and the second rotating protrusion 732 may be rotatably inserted into the first accommodating part 421 of the first rotating arm 420 together with the first connection part 730. The first accommodating part 421 may include a central groove 422a into which the first connection part 730 is inserted, a first sliding groove 422b into which the first rotating protrusion 731 is inserted, and a second sliding groove 422c into which the second rotating protrusion 732 is inserted. The first rotating protrusion 731 may rotate around a third rotation axis A3 (see FIG. 18) within the first sliding groove 422b. The second rotating protrusion 732 may rotate around the third rotation axis A3 within the second sliding groove 422c.

For example, a length L2 (in the y-axis direction, as shown in FIG. 13) of the first rotating protrusion 731 and a length L3 (in the y-axis direction) of the second rotating protrusion 732 may each be less than a length L1 (in the y-axis direction) of the first connection part 730. The length L2 of the first rotating protrusion 731 and the length L3 of the second rotating protrusion 732 may be substantially the same as each other.

For example, the length L2 of the first rotating protrusion 731 and the length L3 of the second rotating protrusion 732 may be different from each other. In this case, the first rotating protrusion 731 may be disposed relatively outside with respect to the second rotating protrusion 732. Here, the "outside" may be a position closer to both ends of the first support plate 710 than to the center of the first support plate 710 based on a length direction of the first support plate 710. For example, a first end (e.g. in the positive y-direction in FIG. 13) of the first rotating protrusion 731 may be closer to the corresponding first end of the first support plate 710 than a second end (e.g. in the negative y-direction in FIG. 13) of the second rotating protrusion 732 is to the corresponding second end of the first support plate 710. The length L2 of the first rotating protrusion 731 may be greater than the length of the second rotating protrusion 732. The length L2 of the first rotating protrusion 731 may be less than the length L1 of the first connection part 730. Therefore, a size relationship between the length L1 of the first connection part 730, the length L2 of the first rotating protrusion 731, and the length L3 of the second rotating protrusion 732 may be expressed by Expression 1 below.

(Expression 1)

$$L1 > L2 > L3$$

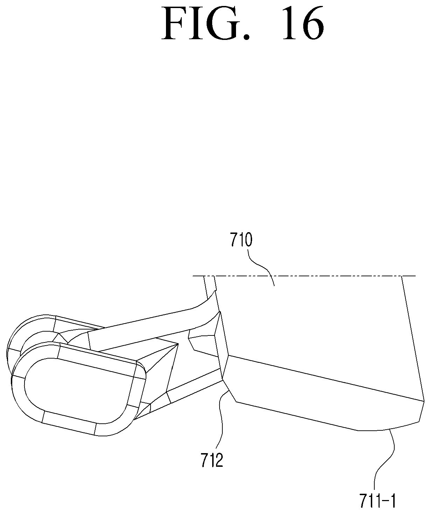

FIGS. 15 and 16 are views showing the first support plate 710 of the first hinge assembly 400 according to an embodiment of the present disclosure.

Referring to FIG. 15, the first connection part 730 may be disposed be inclined downward (e.g. with respect to the z-axis in FIG. 15) from one side of the first support plate 710 in a direction away (e.g. with respect to the x-axis in FIG. 15) from the first support plate 710. The first and second rotating protrusions 731 and 732 may be disposed approximately parallel to the first support plate 710. The first and second rotating protrusions 731 and 732 may each comprise a curved surface. The curved surfaces of the first and second rotating protrusions 731 and 732 may be configured to be accommodated in the corresponding accommodating parts (e.g. first accommodating part 421) of the first rotating arm 420. The curved surfaces of the first and second rotating protrusions 731 and 732 may be configured to enable and guide the rotation of the first and second rotating protrusions 731 and 732 within the corresponding accommodating parts (e.g. first accommodating part 421) of the first rotating arm 420.

For example, a width W1 (e.g. in the x-axis direction in FIG. 15) of the first support plate 710 may be greater than a thickness T1 (e.g. in the z-axis direction in FIG. 15) of the first support plate 710. A width W2 of the first or second rotating protrusion 731 or 732 may be greater than a thickness T2 of the first or second rotating protrusion 731 or 732. The width W1 of the first support plate 710 may be greater than the width W2 of the first or second rotating protrusion 731 or 732. The thickness T1 of the first support plate 710 may be greater than the thickness T2 of the first or second rotating protrusion 731 or 732. Therefore, a ratio of the width W1 to thickness T1 of the first support plate 710 may be greater than a ratio of the width W2 to thickness T2 of the first or second rotating protrusion 731 or 732.

For example, a gap W3 between the first support plate 710 and the first or second rotating protrusion 731 or 732 in a horizontal direction (e.g., an x-axis direction in FIG. 15) may be greater than a gap T3 between the first support plate 710 and the first or second rotating protrusion 731 or 732 in a vertical direction (e.g., a z-axis direction in FIG. 15).

For example, a size relationship between the width W1 of the first support plate 710, the width W2 of the first or second rotating protrusion 731 or 732, and the gap W3 between the first support plate 710 and the first or the second rotating protrusions 731 or 732 in the horizontal direction (e.g. the x-axis direction in FIG. 15) may be expressed by Expression 2 below.

(Expression 2)

$$W1 > W2 > W3$$

For example, a size relationship between the thickness T1 of the first support plate 710, the thickness T2 of the first and the second rotating protrusion 731 or 732, and the gap T3 between the first support plate 710 and the first or second rotating protrusions 731 or 732 in the vertical direction (e.g. the y-axis direction in FIG.15) may be expressed by the following Expression 3.

(Expression 3)

$$T2 > T1 > T3$$

The first support plate 710 may have a first chamfered surface 711 provided at a front end. The first chamfered surface 711 of the first support plate 710 may be a plane formed along the length direction (e.g., a y-axis direction in FIG. 15) of the first support plate 710. The first chamfered surface 711 of the first support plate 710 may slide along a first contact surface 417 (see FIG. 9) provided on an upper surface of the first fixing bracket 410 during the rotation of the first rotating arm 420 (see FIG. 10). Accordingly, a catch (or friction) occurring between the first chamfered surface 711 of the first support plate 710 and the first contact surface 417 of the first fixing bracket 410 during the rotation of the first rotating arm 420 may be alleviated or minimized. Therefore, the first hinge assembly 400 may implement a smooth operation in case of unfolding or folding the second housing part 120 and the third housing part 130. For example, a contact area between the first chamfered surface 711 of the first support plate 710 and the first contact surface 417 of the first fixing bracket 410 may be about 25 to 90 degrees within a rotation angle range of the first rotating arm 420 (e.g., about zero to 90 degrees).

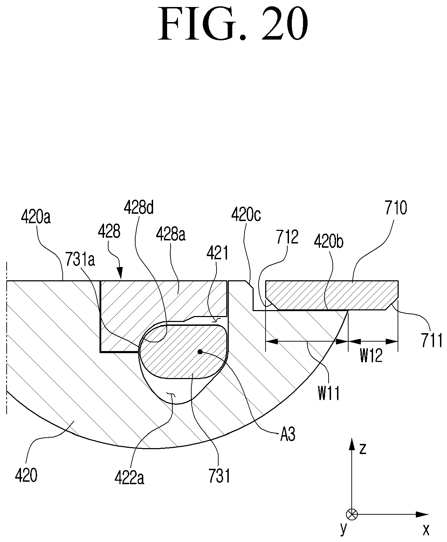

The first support plate 710 may include a second chamfered surface 712 provided at a rear end (e.g., its end adjacent to the first connection part 730). The second chamfered surface 712 may be formed at the rear end of the first support plate 710, thereby preventing the first rotating arm 420 from interfering with a corner of the upper surface 420a of the first rotating arm 420 during the rotation of the first rotating arm 420. To this end, a chamfered surface 420c (see FIG. 20) may be provided at the corner of the upper surface 420a of the first rotating arm 420. A rounded surface (not shown) may also be provided at the corner of the upper surface 420a of the first rotating arm 420.

The size and/or angle of the second chamfered surface 712 of the first support plate 710 may be substantially the same as the size and/or angle of the first chamfered surface 711. However, the size of the second chamfered surface 712 of the first support plate 710 is not limited thereto, and may be smaller than the size of the first chamfered surface 711.

Referring to FIG. 16, a first rounded surface 711-1 having a predetermined curvature may be provided at the front end of the first support plate 710. The second chamfered surface 712 may be provided at the rear end of the first support plate 710. In this way, surfaces of different shapes may be provided at the front and rear ends of the first support plate 710.

A second rounded surface (not shown) having a predetermined curvature may be provided at the rear end of the first support plate 710, similar to the first rounded surface 711-1 provided at the front end of the first support plate 710. For example, if the first rounded surface 711-1 and the second rounded surface are provided at the front and rear ends of the first support plate 710, the second rounded surface may have a curvature less than that of the first rounded surface 711-1.

The rear end of the first support plate 710 may have a right-angled shape by omitting the second chamfered surface 712 or the second rounded surface. In this case, a gap between the rear end of the first support plate 710 and the corner of the upper surface 420a of the first rotating arm 420 may be formed wider to prevent the rear end of the first support plate 710 from interfering with the corner of the upper surface 420a of the first rotating arm 420 during the rotation of the first rotating arm 420.

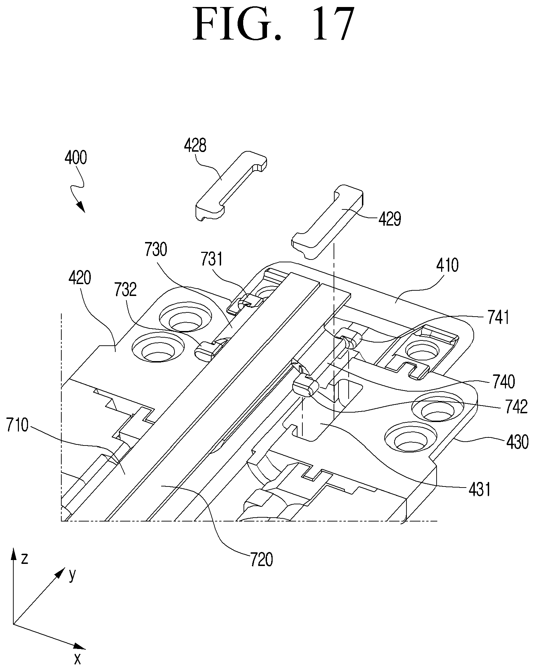

FIG. 17 is an exploded view showing a structure for connecting the first and second support plates 710 and 720 of the first hinge assembly 400 to the first and second rotating arms 420 and 430 according to an embodiment of the present disclosure. FIG. 18 is a view showing the first hinge assembly 400 according to an embodiment of the present disclosure, and is a cross-sectional view taken along lines D-D' and E-E' shown in FIG. 7.

Referring to FIGS. 17 and 18, the first connection part 730 extending from the first support plate 710, the first rotating protrusion 731, and the second rotating protrusion 732 may be inserted into the first accommodating part 421 of the first rotating arm 420, and then the first anti-separation cap 428 may be coupled to the first accommodating part 421. The first connection part 730 extending from the first support plate 710 may rotate without being separated from the first accommodating part 421 of the first rotating arm 420 by using the first anti-separation cap 428. The first support plate 710 may rotate around the third rotation axis A3 passing through the first rotating protrusion 731 and the second rotating protrusion 732. For example, the third rotation axis A3 may be disposed to be parallel to the first rotation axis A1, which is a rotational center of the first rotating arm 420. The third rotation axis A3 may be disposed at a position spaced apart from the first rotation axis A1 by a predetermined distance toward the center of the fixing bracket 410.

The second connection part 740 extending from the second support plate 720, a third rotating protrusion 741 and a fourth rotating protrusion 742 may be inserted into the second accommodating part 431 of the second rotating arm 430, and then the second anti-separation cap 429 may be coupled to the second accommodating part 431. The second connection part 740 extending from the second support plate 720 may rotate without being separated from the second accommodating part 431 of the second rotating arm 430 by using the second anti-separation cap 429. The second support plate 720 may rotate around a fourth rotation axis A4 passing through the third rotating protrusion 741 and the fourth rotating protrusion 742. For example, the fourth rotation axis A4 may be disposed to be parallel to the second rotation axis A2, which is a rotational center of the second rotating arm 430. The fourth rotation axis A4 may be disposed at a position spaced apart from the second rotation axis A2 by a predetermined distance toward the center of the fixing bracket 410.

The first rotation axis A1 and the second rotation axis A2 may be symmetrically disposed to each other relative to a line passing through the center of the fixing bracket 410 along the length direction of the fixing bracket 410 (e.g., a y-axis direction in FIG. 18). The third rotation axis A3 and the fourth rotation axis A4 may be symmetrically disposed to each other relative to the line passing through the center of the fixing bracket 410 along the length direction of the fixing bracket 410 (e.g., the y-axis direction in FIG. 18).

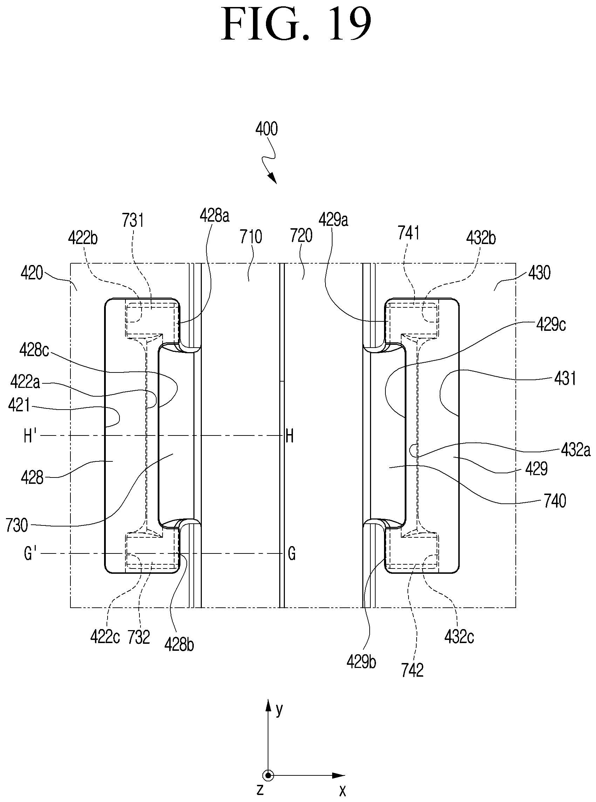

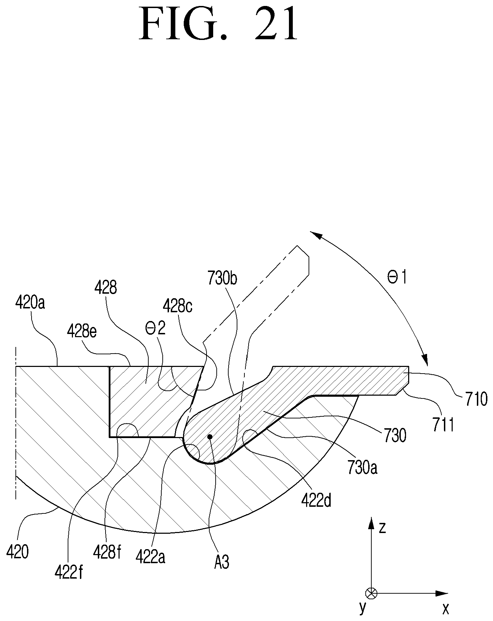

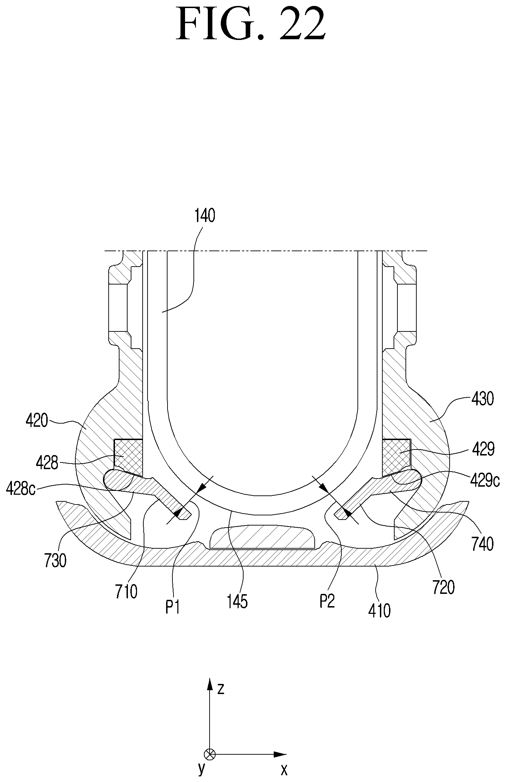

FIG. 19 is an assembly view showing the first and second support plates of the first hinge assembly coupled to the first and second rotating arms by using first and second anti-separation caps according to an embodiment of the present disclosure. FIG. 20 is a view showing the first hinge assembly according to an embodiment of the present disclosure, and is a cross-sectional view taken along line G-G' shown in FIG. 19. FIG. 21 is a view showing the first hinge assembly according to an embodiment of the present disclosure, and is a cross-sectional view taken along line H-H' shown in FIG. 19. FIG. 22 is a view showing an example of the flexible display of the electronic apparatus that is spaced apart from the first and second support plates according to an embodiment of the present disclosure.

Referring to FIGS. 19, 20, and 21, the first anti-separation cap 428 may include a first cover protrusion 428a and a second cover protrusion 428b disposed on one side (e.g., its side adjacent to the first support plate 710) and spaced apart from each other. The first and second cover protrusions 428a and 428b of the first anti-separation cap 428 may respectively correspond to the first and second rotating protrusions 731 and 732 coupled to the first accommodating part 421 of the first rotating arm 420. Therefore, if the first anti-separation cap 428 is coupled to the first accommodating part 421 of the first rotating arm 420, the first and second cover protrusions 428a and 428b of the first anti-separation cap 428 may cover the first and second rotating protrusions 731 and 732.

The first cover protrusion 428a of the first anti-separation cap 428 may form a first guide space for guiding the clockwise or counterclockwise rotation of the first rotating protrusion 731 together with the first sliding groove 422b provided in the first accommodating part 421 of the first rotating arm 420. The first sliding groove 422b may have a shape corresponding to that of a rotation trajectory of the first rotating protrusion 731. A lower part 428d of the first cover protrusion 428a of the first anti-separation cap 428 may have a shape corresponding to that of a rear end 731a of the first rotating protrusion 731. Accordingly, the first rotating protrusion 731 may smoothly rotate around the third rotation axis A3 within the predetermined angle range (e.g., zero to 90 degrees) in the first guide space.

The second cover protrusion 428b of the first anti-separation cap 428 may form a second guide space for guiding the clockwise or counterclockwise rotation of the second rotating protrusion 732 together with the second sliding groove 422c provided in the first accommodating part 421 of the first rotating arm 420. The second guide space may be symmetrically formed with the first guide space.

The second anti-separation cap 429 may be formed substantially the same as the first anti-separation cap 428. The second anti-separation cap 429 may be coupled to the second accommodating part 431 of the second rotating arm 430. In this case, the second anti-separation cap 429 may be symmetrically disposed with the first anti-separation cap 428. If the second anti-separation cap 429 is coupled to the second accommodating part 431 of the second rotating arm 430, the third and fourth cover protrusions 438a and 438b of the second anti-separation cap 429 may cover the third and fourth rotating protrusions 741 and 742.

The third cover protrusion 438a of the second anti-separation cap 429 may form a third guide space for guiding clockwise or counterclockwise rotation of the third rotating protrusion 741 together with a third sliding groove 432b provided in the second accommodating part 431 of the second rotating arm 430. The fourth cover protrusion 438b of the second anti-separation cap 429 may form a fourth guide space for guiding the clockwise or counterclockwise rotation of the third rotating protrusion 741 together with a fourth sliding groove 432c provided in the second accommodating part 431 of the second rotating arm 430. For example, the third guide space may be symmetrically disposed with the first guide space, and the fourth guide space may be symmetrically disposed with the second guide space.

The first connection part 730 of the first support plate 710 may rotate within a predetermined rotation angle range $\theta1$ within the central groove 422a provided in the first accommodating part 421 of the first rotating arm 420. For example, the rotation angle range $\theta1$ of the first connection part 730 of the first support plate 710 may be (or correspond to) an acute angle. That is, the rotation angle range $\theta1$ may be a range from zero degrees to a value less than 90 degrees. The rotation angle range $\theta1$ of the first connection part 730 of the first support plate 710 may be less than the rotation angle range of the first rotating arm 420 (e.g., about zero to 90 degrees).

The first connection part 730 of the first support plate 710 may be restricted from rotating by a first stop surface 442d of the central groove 442a and a second stop surface 428c of the first anti-separation cap 428. That is, a space in which the first connection part 730 can rotate may be delimited by the first stop surface 442d and the second stop surface 428c. For example, a position where a lower surface 730a of the first connection part 730 of the first support plate 710 is in contact with the first stop surface 442d of the central groove 442a may correspond to a lower limit of the rotation angle range $\theta1$ of the first connection part 730 of the first support plate 710. A position where an upper surface 730b of the first connection part 730 of the first support plate 710 is in contact with the second stop surface 428c of the first anti-separation cap 428 may correspond to an upper limit of the rotation angle range $\theta1$ of the first connection part 730 of the first support plate 710.

The upper limit of the rotation angle range $\theta1$ of the first connection part 730 of the first support plate 710 can be determined based on an angle $\theta1$ of the second stop surface 428c of the first anti-separation cap 428. As shown in FIG. 21, the angle $\theta1$ of the second stop surface 428c of the first anti-separation cap 428 can be an angle measured in the counterclockwise direction from an upper surface of the first anti-separation cap 428 to the second stop surface 428c of the first anti-separation cap 428.

The second connection part 740 of the second support plate 720 may rotate within a predetermined rotation angle range within a central groove 432a provided in the second accommodating part 431 of the second rotating arm 430. The second connection part 740 of the second support plate 720 may rotate in a direction opposite to the rotation direction of the first connection part 730 of the first support plate 710. For example, the rotation angle range of the second connection part 740 of the second support plate 720 may be the same as the rotation angle range $\theta1$ of the first connection part 730 of the first support plate 710. An angle of a second stop surface 429c of the second anti-separation cap 429 may be an angle from an upper surface of the second anti-separation cap 429 to a fourth stop surface 429c of the second anti-separation cap 429 in the clockwise direction, as shown in FIG. 22.

Referring to FIG. 22, the upper limit of a rotation angle range $\theta1$ of the first connection part 730 of the first support plate 710 may be an angle at which the first support plate 710 may be spaced apart from the second bending part 145 of the flexible display 140 by a first gap P1 at the second position. An upper limit of a rotation angle range of the second connection part 740 of the second support plate 710 may be an angle at which the second support plate 720 may be spaced apart from the second bending part 145 of the flexible display 140 by a second gap P2 at the second position. In this case, the first gap P1 and the second gap P2 may be substantially the same as each other, and are not limited thereto. For example, the first gap P1 and the second gap P2 may be different from each other.

Referring to FIG. 21, if the first anti-separation cap 428 is coupled to the first accommodating part 421 of the first rotating arm 420, a lower surface 428f of the first anti-separation cap 428 may be seated on a seating surface 422f provided on the first accommodating part 421 of the first rotating arm 420. A depth at which the first anti-separation cap 428 is coupled to the first accommodating part 421 of the first rotating arm 420 may be determined by a distance from the upper surface 420a of the first rotating arm 420 to the seating surface 422f. If the second anti-separation cap 429 is coupled to the second accommodating part 431 of the second rotating arm 430, a lower surface (not shown) of the second anti-separation cap 429 may be seated on a seating surface (not shown) provided on the second accommodating part 431 of the second rotating arm 430.

Each of the first rotating arm 420, the second rotating arm 430, the first anti-separation cap 428, and the second anti-separation cap 429 may include a metal material or synthetic resin (or any other suitable material) having durability, heat resistance, and light weight similar to the first or second support plate 710 or 720.

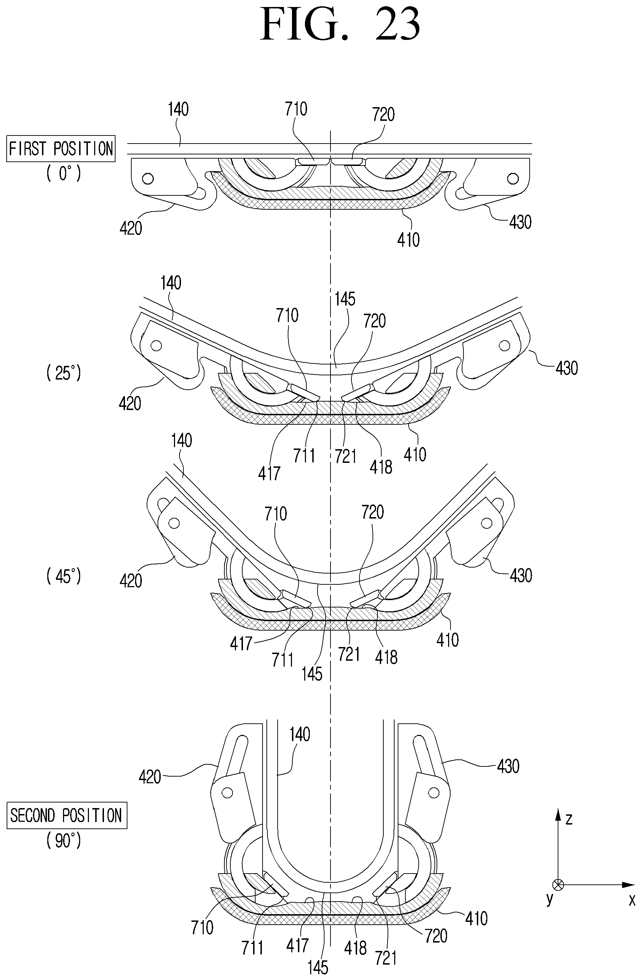

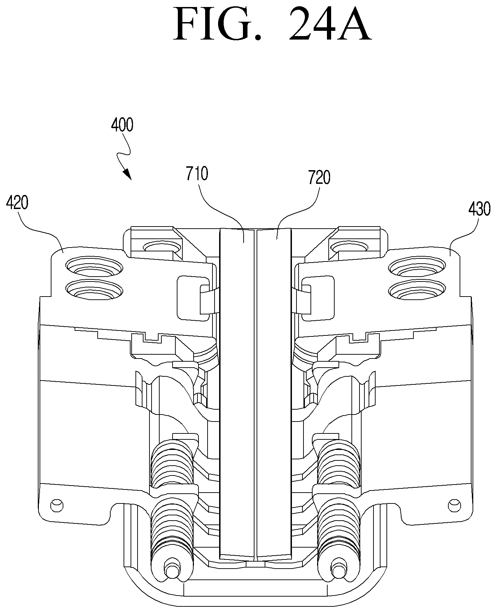

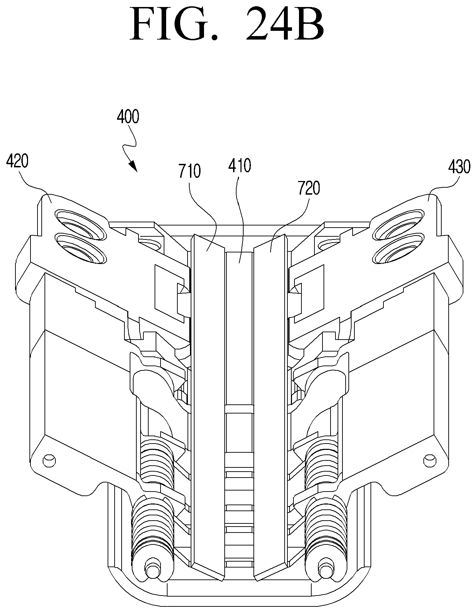

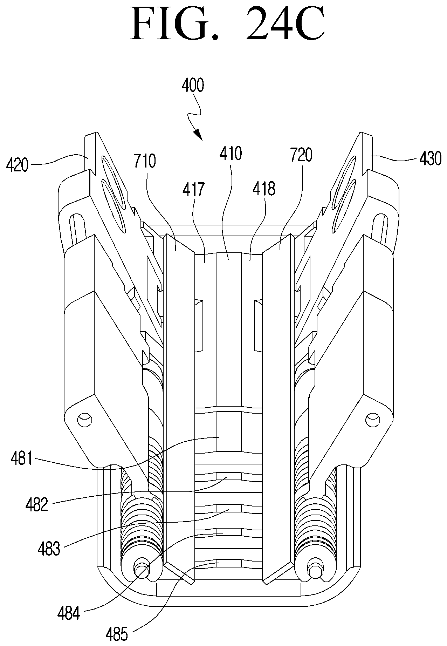

FIG. 23 is a view showing a positional relationship between the second bending part 145 of the flexible display 140 and the first and second support plates 710 and 720 in case that the first hinge assembly 400 is operated according to an embodiment of the present disclosure. FIGS. 24A, 24B, and 24C are views showing the operation of the first hinge assembly 400 according to an embodiment of the present disclosure. For example, FIG. 24A shows a state in which the first and second rotating arms 420 and 430 in FIG. 23 are disposed at zero degrees, FIG. 24B shows a state in which the first and second rotating arms 420 and 430 in FIG. 23 are disposed at 45 degrees, and FIG. 24C shows a state in which the first and second rotating arms 420 and 430 in FIG. 23 are disposed between 45 and 90 degrees.

Referring to FIGS. 23 and 24a, if the first rotating arm 420 and the second rotating arm 430 are at the first position (e.g., about zero degrees relative to the x-axis, or 180 degrees with respect to each other), the first support plate 710 and the second support plate 720 may support the second bending part 145 of the flexible display 140. In this case, the first support plate 710 and the second support plate 720 may contact the second bending part 145 of the flexible display 140.

If the second housing part 120 and the third housing part 130 rotate from the first position to the second position, the first rotating arm 420 may rotate clockwise around the first rotation axis A1, as shown in FIG. 23 (see FIG. 18), and the second rotating arm 430 may rotate counterclockwise around the second rotation axis A2, as shown in FIG. 23 (see FIG. 18).

At a point where the first rotating arm 420 and the second rotating arm 430 rotate from the first position toward the second position by about 25 degrees (relative to the x-axis, or about 130 degrees with respect to each other), the first support plate 710 and the second support plate 720 may be spaced apart from the second bending part 145 of the flexible display 140. A separation distance of the first support plate 710 or the second support plate 720 from the second bending part 145 of the flexible display 140 may gradually increase from an angle at which the support plate rotate away from the first position to about 25 degrees. For example, the support plate 710 or the second support plate 720 may only contact the flexible display when the first rotating arm 420 and the second rotating arm 430 are at (or very near) the first position, and may begin to lose contact with the flexible display when the first rotating arm 420 and the second rotating arm 430 begin to move away from the first position toward the second position.

Up to a point where the first rotating arm 420 and the second rotating arm 430 rotate from the first position toward the second position by about zero degrees to 25 degrees, the first support plate 710 may rotate together with the first rotating arm 420 in the same direction as the rotation direction of the first rotating arm 420 (e.g., clockwise as shown in FIG. 23), and the second support plate 720 may rotate together with the second rotating arm 430 in the same direction as the rotation direction of the second rotating arm 430 (e.g., counterclockwise as shown in FIG. 23).

The first chamfered surface 711 of the first support plate 710 and a third chamfered surface 721 provided at the front end of the second support plate 720 may contact the first and second contact surface 417 and 418 of the fixing bracket 410, respectively, from a point of about 25 degrees. For example, the first contact surface 417 and the second contact surface 418 may be formed as curved surfaces each having a gentle curvature to thus alleviate or minimize a catch (or friction) occurring during the rotation of the first support plate 710 and the second support plate 720. Referring to FIGS. 23 and 24B, up to a point where the first rotating arm 420 and the second rotating arm 430 rotate from the first position toward the second position by about 25 degrees to about 45 degrees, the first chamfered surface 711 of the first support plate 710 and the third chamfered surface 721 of the second support plate 720 may slide along the first and second contact surfaces 417 and 418 of the fixing bracket 410, respectively. In this case, the first support plate 710 may rotate around the third rotation axis A3 (see FIG. 18) in the direction (e.g., counterclockwise as shown in FIG. 23) opposite to the rotation direction of the first rotating arm 420. The second support plate 720 may rotate around the fourth rotation axis A4 (see FIG. 18) in the direction (e.g., clockwise as shown in FIG. 23) opposite to the rotation direction of the second rotating arm 430. The first support plate 710 or the second support plate 720 may continuously maintain the separation distance from the second bending part 145 of the flexible display 140 up to a point where the first rotating arm 420 and the second rotating arm 430 rotate from the first position toward the second position by about 25 degrees (relative to the x-axis, or about 130 degrees with respect to each other) to about 45 degrees (relative to the x-axis, or about 90 degrees with respect to each other).

Referring to FIGS. 23 and 24C, at a point where the first rotating arm 420 and the second rotating arm 430 rotate from the first position toward the second position by about 45 degrees to about 90 degrees, the first support plate 710 may be restricted from rotating by the second stop surface 428c of the first anti-separation cap 428, and the second support plate 720 may be restricted from rotating by the fourth stop surface 429c of the second anti-separation cap 429 (see FIG. 22).

The first support plate 710 and the second support plate 720 may continuously maintain the separation distance from the second bending part 145 of the flexible display 140 up to the point where the first rotating arm 420 and the second rotating arm 430 rotate from the first position toward the second position by from about 45 degrees (relative to the x-axis, or about 90 degrees with respect to each other) to about 90 degrees (relative to the x-axis, or about 0 degrees with respect to each other).

The first support plate 710 and the second support plate 720 may be restricted from rotating toward the second bending part 145 of the flexible display 140 from the second position, and accordingly, the second bending part 145 of the flexible display 140 may not be scratched or damaged by the first support plate 710 and the second support plate 720 even if the external impact is applied to the electronic apparatus 100. If the second housing part 120 and the third housing part 130 rotate from the second position to the first position, the rotation direction of the first rotating arm 420, the second rotating arm 430, the first support plate 710, or the second support plate 720 may be opposite to the direction in which the second housing part 120 and the third housing part 130 rotate from the second position to the first position. The first support plate 710 or the second support plate 720 may have the separation distance from the second bending part 145 of the flexible display 140 while the first rotating arm 420 and the second rotating arm 430 rotate from the second position to the first position. If the second housing part 120 (see FIG. 8) and the third housing part 130 (see FIG. 8) rotate from the first position to the second position, the first and second rotating arms 420 and 430 of the first hinge assembly 400 may rotate substantially simultaneously and by substantially the same angle in the opposite directions. The first and second support plates 710 and 720 of the first hinge assembly 400 may rotate in linkage with the rotation of the first and second rotating arms 420 and 430, and continuously maintain a state in which the support plates are spaced apart from the flexible display 140 by the predetermined gap from the point where the support plates leave the first position to the second position. It will be appreciated that the predetermined gap between the flexible display 140 and the support plates may vary during the rotation of the first and second rotating arms 420 and 430.

Referring to FIG. 24C, the first chamfered surface 711 of the first support plate 710 and the third chamfered surface 721 of the second support plate 720 may slide along each of the upper surfaces of the slider 481, the first cam member 482, the first axis bracket 483, the second cam member 484, the second axis bracket 485, and the fixing block 490 (see FIG. 12) together with the first and second contact surfaces 417 and 418 of the fixing bracket 410 while rotating from the first position to the second position. In this case, each of the upper surfaces of the slider 481, the first cam member 482, the first axis bracket 483, the second cam member 484, the second axis bracket 485, and the fixing block 490 may include a curved surface corresponding to the first or second contact surface 417 or 418 of the fixing bracket 410.

The first chamfered surface 711 of the first support plate 710 and the third chamfered surface 721 provided at the front end of the second support plate 720 may contact the first and second contact surfaces 417 and 418 of the fixing bracket 410 from the point of about 25 degrees, respectively. For example, the first contact surface 417 and the second contact surface 418 may be formed as the curved surfaces each having a gentle curvature to thus alleviate or minimize the catch (or friction) occurring during the rotation of the first support plate 710 and the second support plate 720.

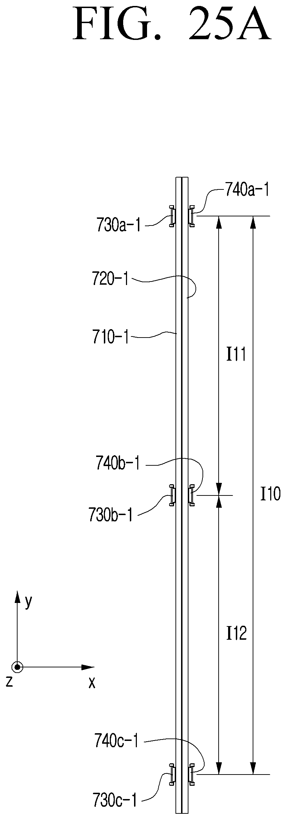

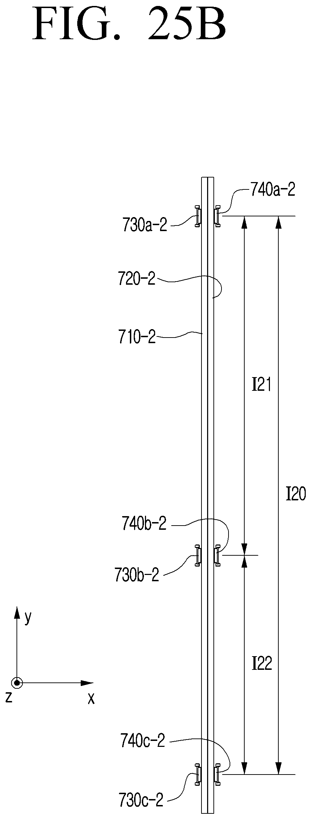

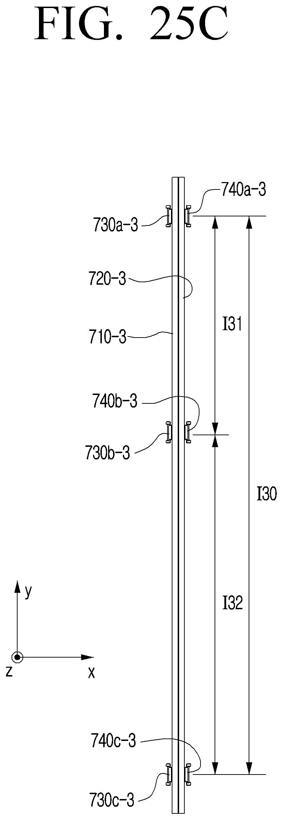

FIGS. 25A, 25B, and 25C are views showing the first support plates 710-1, 710-2, and 710-3 and second support plates 720-1, 720-2, and 720-3 of the first hinge assembly 400 according to an embodiment of the present disclosure.

Referring to FIG. 25A, the first support plate 710-1 may include a plurality of first connection parts arranged along one side. For example, the first support plate 710-1 may include three first connection parts 730a-1, 730b-1, and 730c-1 arranged at predetermined intervals. A gap I11 between the upper first connection part 730a-1 disposed on an upper side of the first support plate 710-1 and the middle first connection part 730b-1 disposed approximately in the center of the first support plate 710-1 may be substantially the same as a gap I12 between the middle first connection part 730b-1 and the lower first connection part 730c-1 disposed on a lower side of the first support plate 710-1. The second support plate 730-1 may include three second connection parts 740a-1, 740b-1, and 740c-1 corresponding to the three first connection parts 730a-1, 730b-1, and 730c-1 of the first support plate 710-1.

In this way, the first support plate 710-1 and the second support plate 720-1, each of which includes the three first connection parts 730a-1, 730b-1, and 730c-1 and the three second connection parts 740a-1, 740b-1, and 740c-1, may be applied to the second hinge structure 160 including the three hinge assemblies 400, 500, and 600 as shown in FIG. 6B.

Referring to FIG. 25B, a spacing between three first connection parts 730a-2, 730b-2, and 730c-2 of a first support plate 710-2 and a spacing between three first connection parts 740a-2, 740b-2, and 740c-2 of a second support plate 730-2 may be different from each other depending on positions of the three hinge assemblies 400, 500, and 600 disposed on the second hinge cover 161 (see FIG. 6B).

For example, a gap between the first accommodating part 421 of the first hinge assembly 400 and the first accommodating part 621 of the third hinge assembly 600 may be greater than a gap between the first accommodating part 621 of the third hinge assembly 600 and the first accommodating part 521 of the second hinge assembly 500. The second accommodating parts 431, 531, and 631 of the first, second, and third hinge assemblies 400, 500, and 600 may be disposed at positions corresponding to the first accommodating parts 421, 521, and 621 of the first, second, and third hinge assemblies 400, 500, and 600, respectively. In this case, a gap I21 between the upper first connection part 730a-2 and the middle first connection part 730b-2 may be greater than a gap I22 between the middle first connection part 730b-2 and the lower first connection part 730c-2. The three second connection parts 740a-2, 740b-2, and 740c-2 of the second support plate 730-2 may be disposed at positions corresponding to the three first connection parts 730a-2, 730b-2, and 730c-2 of the first support plate 710-2.

Referring to FIG. 25C, a gap between the first accommodating part 421 of the first hinge assembly 400 and the first accommodating part 621 of the third hinge assembly 600 may be less than a gap between the first accommodating part 621 of the third hinge assembly 600 and the first accommodating part 521 of the second hinge assembly 500. The second accommodating parts 431, 531, and 631 of the first, second, and third hinge assemblies 400, 500, and 600 may be disposed at positions corresponding to the first accommodating parts 421, 521, and 621 of the first, second, and third hinge assemblies 400, 500, and 600, respectively. In this case, a gap I31 between an upper first connection part 730a-3 and a middle first connection part 730b-3 may be greater than a gap 132 between the middle first connection part 730b-3 and a lower first connection part 730c-3. Three second connection parts 740a-3, 740b-3, and 740c-3 of a second support plate 730-3 may be disposed at positions corresponding to the three first connection parts 730a-3, 730b-3, and 730c-3 of the first support plate 710-3.

Although the support plates illustrated in FIGS. 25A, 25B, and 25C include three connection parts with particular spacing arrangements, it will be appreciated that any suitable number and arrangement of connection parts may be used.

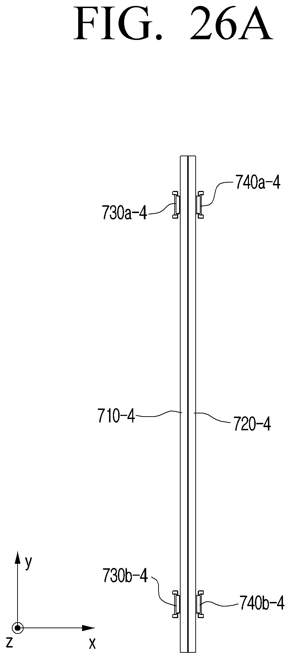

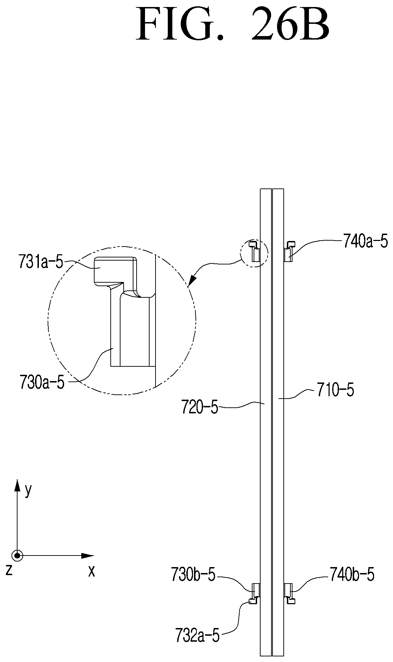

FIGS. 26A and 26B are views showing the first support plates 710-4 and 710-5 and second support plates 720-4 and 720-5 of the first hinge assembly 400 according to an embodiment of the present disclosure.

The number of first connection parts provided on the first support plate and the number of second connection parts provided on the second support plate may differ depending on a length of the second hinge structure 160 applied to the electronic apparatus 100. For example, the length of the second hinge structure 160 shown in FIG. 4 (e.g., a length in the y-axis direction in FIG. 4) may be less than a length of the second hinge structure 160 shown in FIG. 6B (e.g., a length in the y-axis direction in FIG. 6B). In this case, the second hinge structure 160 shown in FIG. 4 may include two hinge assemblies 400 and 500 in consideration of the length.

Referring to FIG. 26Aa, the first support plate 710-4 applied to the second hinge structure 160 including the two hinge assemblies 400 and 500 may include two first connection parts 730a-4 and 730a-4 and the second support plate 720-4 may include two second connection parts 740a-4 and 740a-4.

Referring to FIG. 26B, two first connection parts 740a-5 and 740b-5 provided on the first support plate 710-5 may correspond to respective halves of the two first connection parts 740a-4 and 740b-4 shown in FIG. 26A. For example, the upper first connection part 740a-5 may include one first rotating protrusion 731a-5 disposed adjacent to an upper side of the first support plate 710-5. The lower first connection part 740b-5 may include one second rotating protrusion 732a-5 disposed adjacent to a lower side of the first support plate 710-5. The two second connection parts 740a-5 and 740b-5 of the second support plate 730-5 may be symmetrically disposed with the two first connection parts 730a-5 and 730b-5 of the first support plate 710-5.

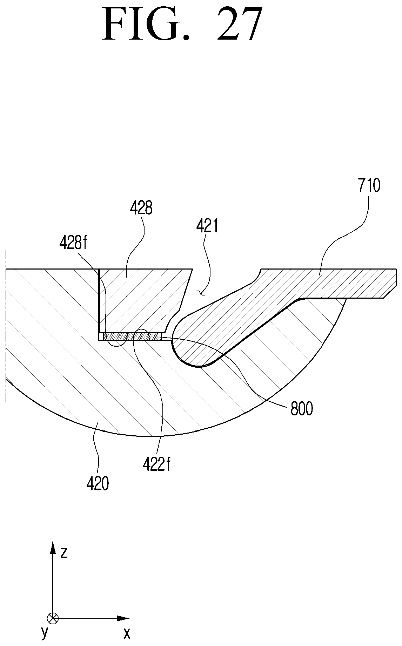

FIG. 27 is a view showing an example in which the anti-separation cap of the first hinge assembly according to an embodiment of the present disclosure is attached to the first housing part by using an adhesive member.

Referring to FIG. 27, the first anti-separation cap 428 may be firmly coupled to the first accommodating part 421 of the first rotating arm 420 by using an adhesive member 800. For example, the adhesive member 800 may be applied to the seating surface 422f of the first accommodating part 421. The lower surface 428f of the first anti-separation cap 428 may be attached to the seating surface 422f of the first accommodating part 421 by using the adhesive member 800. The second anti-separation cap 429 may also be attached to the seating surface of the second accommodating part 431 (see FIG. 10) by using the adhesive member 800. Accordingly, the first anti-separation cap 428 and the second anti-separation cap 429 may maintain a state in which the caps are assembled to the first and second accommodating parts 421 and 431 without being separated from the first and second accommodating parts 421 and 431 due to the external impact applied to the electronic apparatus 100.

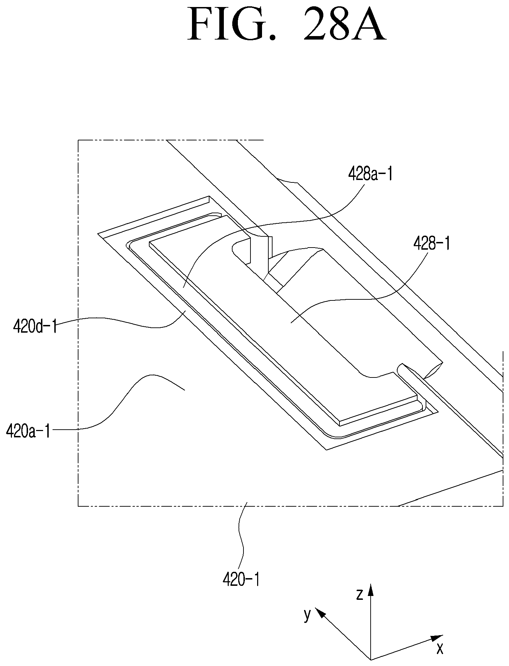

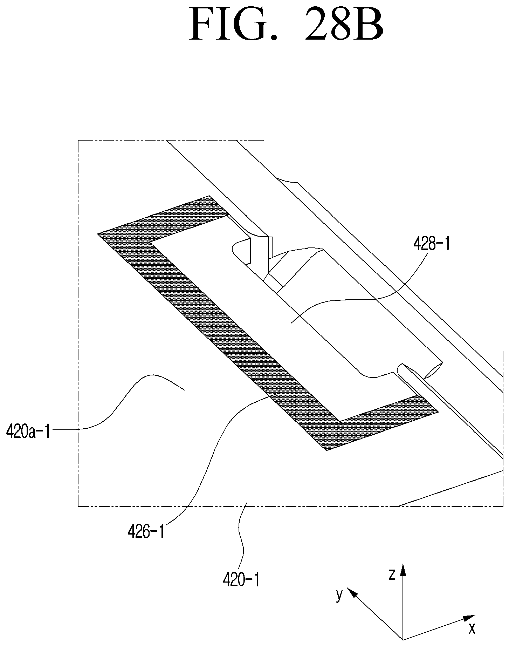

FIG. 28A is a view showing an example in which a slit groove is formed to fix the anti-separation cap of the first hinge assembly according to an embodiment of the present disclosure to the first housing part by welding. FIG. 28B is a view showing an example in which a filler metal fills the slit groove shown in FIG. 28A.

Referring to FIG. 28A, if a first anti-separation cap 428-1 and a first rotating arm 420-1 are made of metal (e.g., stainless steel, alloy steel, or aluminum), the first anti-separation cap 428-1 may be fixed to a first accommodating part 421-1 of the first rotating arm 420-1 by welding.

For example, a first slit groove 420a-1 may be formed along a periphery of the first accommodating part 421-1 of the first rotating arm 420-1. A second slit groove 428a-1 may be formed along a portion of an upper surface of the first anti-separation cap 428-1 to correspond to a first slit groove 420d-1.

Referring to FIG. 28B, the first slit groove 420d-1 and the second slit groove 428a-1 may be filled with the filler metal by using arc welding, gas metal arc welding, or laser welding. The first anti-separation cap 428-1 and the first rotating arm 420-1 may be welded to each other by using the filler metal. The filler metal filling the first slit groove 420d-1 and the second slit groove 428a-1 is referred to as a welded portion 426-1. The welded portion 426-1 formed in the first slit groove 420d-1 or the second slit groove 428a-1 may protrude beyond the upper surface 420a-1 of the first rotating arm 420-1. In this case, the flexible display 140 (see FIG. 23) may have the rear surface in contact with the welded portion 426-1 at the first position. To alleviate marking or damage to the rear surface of the flexible display 140 due to the welded portion 426-1 protruding from the upper surface 420a-1 of the first rotating arm 420-1, the welded portion 426-1 may be polished to have substantially the same height as the upper surface 420a-1 of the first rotating arm 420-1 through a polishing process. For example, the polishing process may sequentially perform rough grinding, precision grinding, and polishing (or buffing) to minimize surface roughness of the welded portion 426-1.

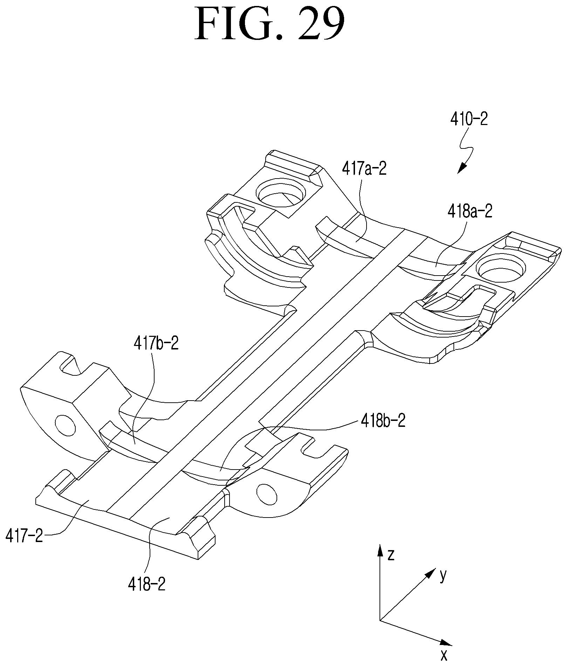

FIG. 29 is a view showing a fixing bracket 410-2 according to an embodiment of the present disclosure.

Referring to FIG. 29, the fixing bracket 410-2 may include a pair of first contact protrusions 417a-2 and 417b-2 and a pair of second contact protrusions 418a-2 and 418b-2, which may come into contact with the first chamfered surface 711 of the first support plate 710 (see FIG. 23) and the third chamfered surface 721 of the second support plate 720 (see FIG. 23), respectively.

The pair of first contact protrusions 417a-2 and 417b-2 may be disposed on a first contact surface 417-2 of the fixing bracket 410-2 at a predetermined interval along a length direction (e.g., a y-axis direction in FIG. 29) of the fixing bracket 410-2. The pair of second contact protrusions 418a-2 and 418b-2 may be disposed on a second contact surface 418-2 of the fixing bracket 410-2 at positions corresponding to those of the pair of first contact protrusions 417a-2 and 417b-2.

If the first support plate 710 rotates from the first position to the second position or from the second position to the first position, the first chamfered surface 711 (or the first rounded surface 711-1) of the first support plate 710 may slide along the pair of first contact protrusions 417a-2 and 417b-2. If the second support plate 720 rotates from the first position to the second position or from the second position to the first position, the third chamfered surface 721 (or a third rounded surface (not shown)) of the second support plate 720 may slide along the pair of second contact protrusions 418a-2 and 418b-2. The third rounded surface of the second support plate 720 may be formed substantially the same as the first rounded surface 711-1 of the first support plate 710.

In this case, a contact area between the first support plate 710, the second support plate 720, and the fixing bracket 410-2 may be significantly reduced, thereby alleviating or minimizing the catch (or friction) occurring during the rotation of the first support plate 710 and the second support plate 720.

The pair of first contact protrusions 417a-2 and 417b-2 and the pair of second contact protrusions 418a-2 and 418b-2 may each include a curved surface having a gentle curvature on an upper surface in contact with the first chamfered surface 711 (or the first rounded surface 711-1) of the first support plate 710 or the third chamfered surface 721 (or the third rounded surface) of the second support plate 720. Accordingly, the first support plate 710 and the second support plate 720 may smoothly slide.

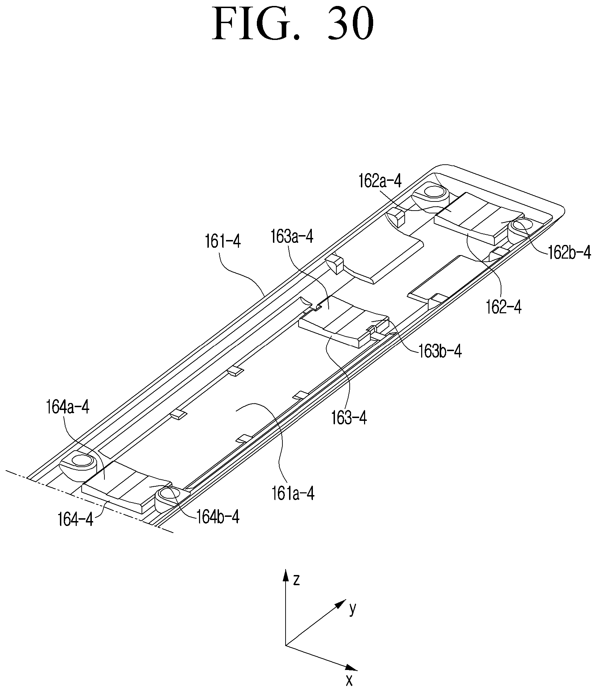

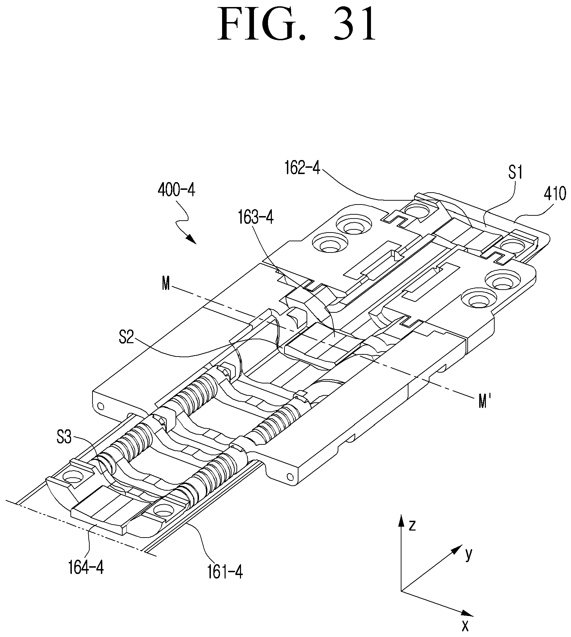

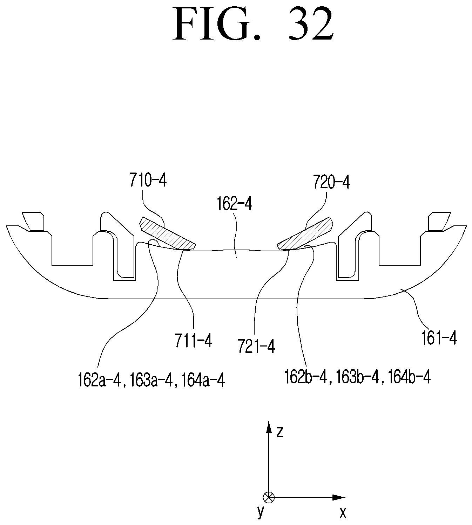

FIG. 30 is a view showing a second hinge cover 161-4 according to an embodiment of the present disclosure. FIG. 31 is a view showing a first hinge assembly 400-4 coupled to the second hinge cover 161-4 according to an embodiment of the present disclosure. FIG. 32 is a view showing an example of the front ends of the first and second support plates in contact with the contact protrusion of the second hinge cover of the electronic apparatus according to an embodiment, and is a cross-sectional view taken along line M-M' shown in FIG. 31.

Referring to FIGS. 30, 31, and 32, the second hinge cover 161-4 may include a plurality of contact protrusions spaced apart from each other along an upper surface 161a-4 of the second hinge cover 161-4. For example, the plurality of contact protrusions of the second hinge cover 161-4 may include third, fourth, and fifth contact protrusions 162-4, 163-4, and 164-4. The third, fourth and fifth contact protrusions 162-4, 163-4, and 164-4 of the second hinge cover 161-4 may allow a first chamfered surface 711-4 (or the first rounded surface 711-1, see FIG. 16) of the first support plate 710-4 and a third chamfered surface 721-4 (or a third rounded surface) of the second support plate 720-4 to slide if the first support plate 710-4 and the second support plate 720-4 rotate.

The third, fourth, and fifth contact protrusions 162-4, 163-4, and 164-4 may include first contact parts 162a-4, 163a-4, and 164a-4 in contact with the first chamfered surface 711-4 (or the first rounded surface 711-1) of the first support plate 710-4, and second contact parts 162b-4, 163b-4, and 164b-4 in contact with the third chamfered surface 721-4 (or the third rounded surface) of the second support plate 720-4. For example, each of the third, fourth, and fifth contact protrusions 162-4, 163-4, and 164-4 may include a curved surface having a gentle curvature. Accordingly, the first support plate 710-4 and the second support plate 720-4 may slide smoothly along the third, fourth, and fifth contact protrusions 162-4, 163-4, and 164-4.

The number of third, fourth, fifth contact protrusions 162-4, 163-4, and 164-4 provided on the second hinge cover 161-4 is not limited to three. For example, the number of contact protrusions provided on the second hinge cover 161-4 may be the same as the number of hinge assemblies included in the second hinge structure 160.

If mounted on the upper surface 161a-4 of the second hinge cover 161-4, the first hinge assembly 400 may be stably disposed on the upper surface of the second hinge cover 161-4 without being interfered with by the third, fourth, and fifth contact protrusions 162-4, 163-4, and 164-4 protruding from the upper surface 161a-4 of the second hinge cover 161-4. In this case, the third, fourth, and fifth contact protrusions 162-4, 163-4, and 164-4 of the second hinge cover 161-4 may be inserted into spaces S1, S2, and S3 provided in the first hinge assembly 400.

The first contact parts 162a-4, 163a-4, and 164a-4 and second contact parts 162b-4, 163b-4, and 164b-4 of the third, fourth, and fifth contact protrusions 162-4, 163-4, and 164-4 may be disposed higher (e.g. in the z-axis direction of FIG. 31) than the first and second contact surfaces 417 and 418 (see FIG. 9) of the fixing bracket 410. In this case, the first support plate 710-4 and the second support plate 720-4 may not be in contact with the respective components of the first hinge assembly 400-4 during the rotation, and may slide in contact with the first contact parts 162a-4, 163a-4, and 164a-4 and second contact parts 162b-4, 163b-4, and 164b-4 of the third, fourth, and fifth contact protrusions 162-4, 163-4, and 164-4.

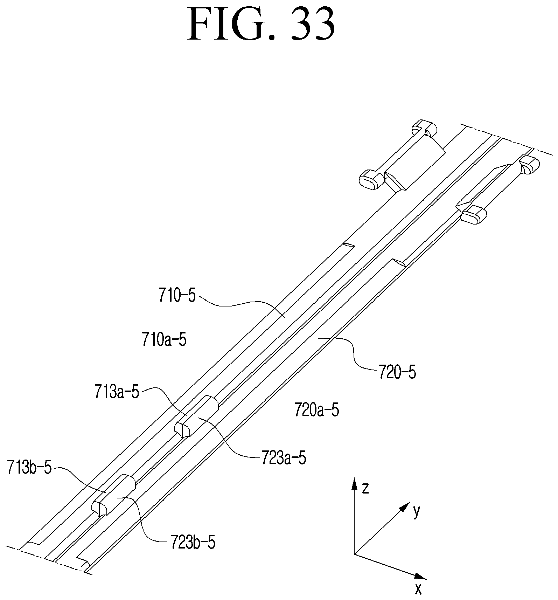

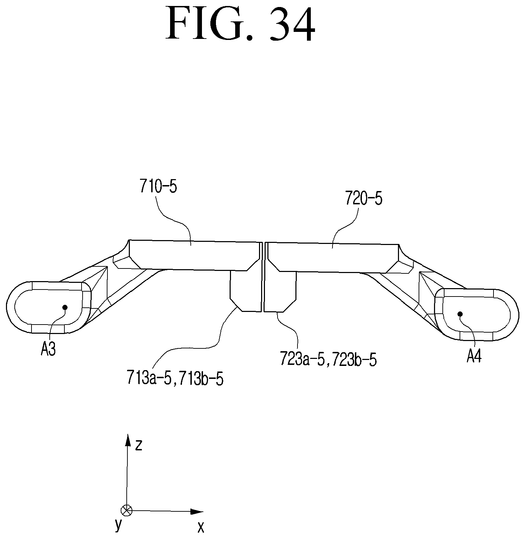

FIGS. 33 and 34 are views showing the first support plate 710-5 and second support plate 720-5 according to an embodiment of the present disclosure.

Referring to FIGS. 33 and 34, the first support plate 710-5 may include a pair of first rotation restriction protrusions 713a-5 and 713b-5 disposed to face the second support plate 720-5. The pair of first rotation restriction protrusions 713a-5 and 713b-5 may protrude from a bottom surface 710a-5 of the first support plate 710-5 by a predetermined length.

The second support plate 720-5 may include a pair of second rotation restriction protrusions 723a-5 and 723b-5 disposed to face the first support plate 710-5. The pair of second rotation restriction protrusions 723a-5 and 723b-5 may protrude from the bottom surface 710a-5 of the first support plate 710-5 toward the second hinge cover 161 (see FIG. 6B) by the predetermined length.

The pair of second rotation restriction protrusions 723a-5 and 723b-5 may be disposed at positions corresponding to those of the pair of first rotation restriction protrusions 713a-5 and 713b-5. The pair of first rotation restriction protrusions 713a-5 and 713b-5 and the pair of second rotation restriction protrusions 723a-5 and 723b-5 may be disposed at positions avoiding interference with the components of the first hinge assembly 400 to prevent the first support plate 710-5 and the second support plate 720-5 from interfering with the rotation operation.

At the first position (see the first state 100a in FIG. 1 or the third state 100 of FIG. 3), the first support plate 710-5 may rotate counterclockwise around the third rotation axis A3 as shown in FIG. 34 and the second support plate 720-5 may rotate clockwise around the fourth rotation axis A4 as shown in FIG. 34, if the external impact is applied to the electronic apparatus 100. Here, the pair of first rotation restriction protrusions 713a-5 and 713b-5 and the pair of second rotation restriction protrusions 723a-5 and 723b-5 may come into contact with each other, thereby restricting the counterclockwise rotation of the first support plate 710-5 and the clockwise rotation of the second support plate 720-5. Accordingly, at the first position, the first support plate 710-5 and the second support plate 720-5 may be prevented from rotating toward the rear surface of the flexible display 140 (see FIG. 1) due to the external impact. As a result, the flexible display 140 (see FIG. 1) may be prevented from being scratched or damaged by the front end of the first support plate 710-5 or the front end of the second support plate 720-5.

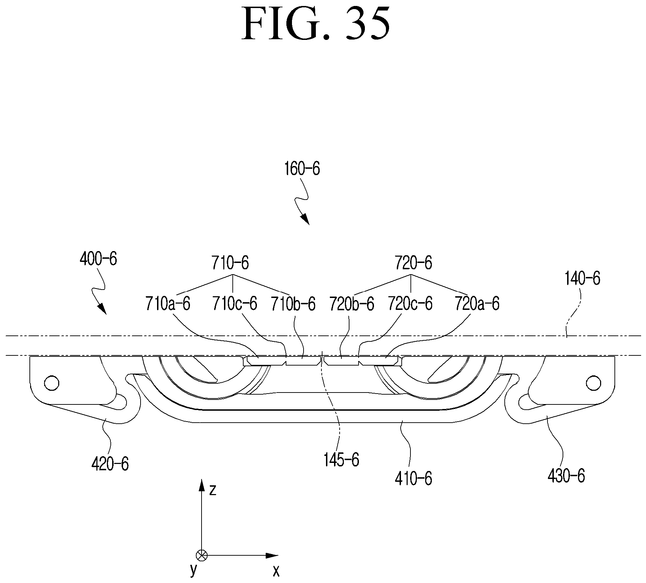

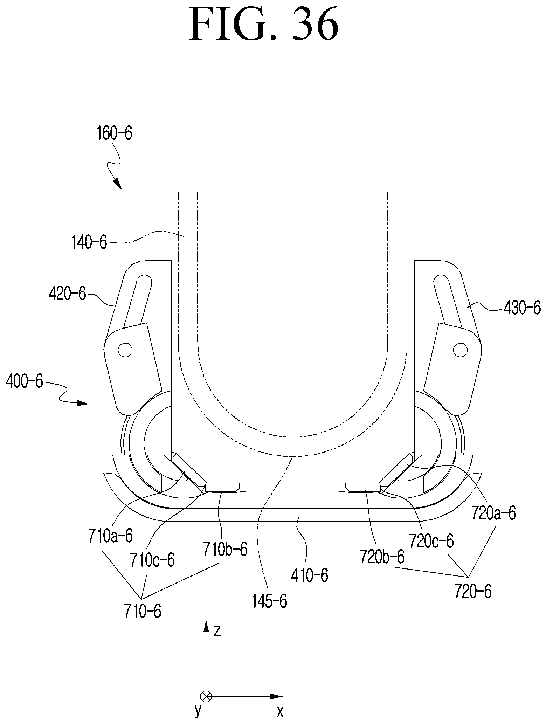

FIGS. 35 and 36 are views showing an example in which each of first and second support plates 710-6 and 720-6 of a first hinge assembly 400-6 includes a segmented structure according to an embodiment.

Referring to FIGS. 35 and 36, the first support plate 710-6 and the second support plate 720-6 including the segmented structure may be applied to a case where a distance between the first rotation axis A1 and the second rotation axis A2 in a second hinge structure 160-6 becomes wider.

The first support plate 710-6 and the second support plate 720-6 may each have the segmented structure. For example, the first support plate 710-6 may include a first segmented part (or segment) 710a-6, a second segmented part (or segment) 710b-6, and the first segmented part 710a-6 may be rotatably connected to the second segmented part 710b-6 (for example the first support plate 710-6 may include a first living hinge 710c-6 connecting the first segmented part 710a-6 to the second segmented part 710b-6). The first living hinge 710c-6 may be disposed along a length direction (e.g., a y-axis direction in FIG. 35) of the first support plate 710-6. A thickness of the first living hinge 710c-6 may be less than a thicknesses of the first segmented part 710a-6 or the second segmented part 710b-6. The first living hinge 710c-6 may be formed integrally with the first segmented part 710a-6 and the second segmented part 710b-6. The second support plate 720-6 may include a third segmented part (or segment) 720a-6, a fourth segmented part (or segment) 720b-6, and the third segmented part 720a-6 may be rotatably connected to the fourth segmented part 720b-6 (for example the second support plate 720-6 may include a second living hinge 720c-6 connecting the third segmented part 720a-6 to the fourth segmented part 720b-6. The second support plate 720-6 may include the segmented structure substantially the same as that of the first support plate 710-6.

If a first rotating arm 420-6 and a second rotating arm 430-6 are at the first position, the first and second support plates 710-6 and 720-6 may support the second bending part 145 of the flexible display 140 as shown in FIG. 35. In this case, the first and second segmented parts 710a-6 and 710b-6 of the first support plate 710-6 may be disposed in an approximately horizontal direction (e.g., an x-axis direction in FIG. 35). The third and fourth segmented parts 720a-6 and 720b-6 of the second support plate 720-6 may be disposed in the approximately horizontal direction (e.g., the x-axis direction in FIG. 35).

The first support plate 710-6 and the second support plate 720-6 each including the segmented structure may have a greater width (e.g. in the x-axis direction in FIG. 35) than the first support plate 710 (see FIG. 18) and the second support plate 720 (see FIG. 18) each including no segmented structure. Therefore, the first support plate 710-6 and the second support plate 720-6 may stably support the second bending part 145 of the flexible display 140 at the first position.

While the first rotating arm 420-6 and the second rotating arm 430-6 rotate from the first position to the second position, as shown in FIG. 36, the first and second segmented parts 710a-6 and 710b-6 of the first support plate 710-6 may be bent about the first living hinge 710c-6, and the third and fourth segmented parts 720a-6 and 720b-6 of the second support plate 720-6 may be bent about the second living hinge 720c-6.

In this way, the first support plate 710-6 and the second support plate 720-6 are bent toward a fixing bracket 410-6 by using the first living hinge 710c-6 and the second living hinge 720c-6 while rotating from the first position to the second position, thereby maintaining their separation distance from the flexible display 140. As a result, the flexible display 140 may be prevented from being scratched or damaged by the first support plate 710 and the second support plate 720.

The first support plate 710-6 and the second support plate 720-6 may be bent about the first living hinge 710c-6 and the second living hinge 720c-6, respectively, if the second housing part 120 and the third housing par 130 are folded in a direction in which the housing parts face each other. In this case, rotational radii of the first support plate 710-6 and the second support plate 720-6 may be reduced to thus prevent a size of the first hinge assembly 400-6 from increasing (e.g., the first hinge assembly 400-6 having an increased thickness along the z-axis direction), thereby preventing an increase in the size of the electronic apparatus.

According to an embodiment, the foldable electronic apparatus 100 may include: a foldable housing 101 including the first housing part 110, the second housing part 120, and the third housing part 130; the first hinge structure 150 rotatably connecting the first housing part and the second housing part with each other; the second hinge structure 160 rotatably connecting the second housing part and the third housing part with each other and including the first hinge assembly 400; the first hinge cover 151 covering the first hinge structure; the second hinge cover 161 covering the second hinge structure; and the flexible display 140 disposed across the first housing part, the second housing part, and the third housing part.

According to an embodiment, the first hinge assembly 400 may include: the first fixing bracket 410 fixed to the second hinge cover; the first rotating arm 420 having one end rotatably connected to the first side of the first fixing bracket and the other end fixed to the second housing part; the second rotating arm 430 having one end rotatably connected to the second side of the first fixing bracket and the other end fixed to the third housing part;

the first support plate 710, 710-1, 710-2, 710-3, 710-4, or 710-5 rotatably connected to the first rotating arm; and the second support plate 720, 720-1, 720-2, 720-3, 720-4, or 720-5 rotatably connected to the second rotating arm.

According to an embodiment, the first support plate 710, 710-1, 710-2, 710-3, 710-4, or 710-5 and the second support plate 720, 720-1, 720-2, 720-3, 720-4, or 720-5, the second housing part, and the third housing part may support the flexible display in the unfolded state and be spaced apart from each other in linkage with the rotation of the second housing part and the third housing part as the second housing part and the third housing part move from the unfolded state to the folded state. According to an embodiment, the first support plate 710, 710-1, 710-2, 710-3, 710-4, or 710-5 and the second support plate 720, 720-1, 720-2, 720-3, 720-4, or 720-5 may retract toward the second hinge cover 161 to be spaced apart from the flexible display while the folding portion of the flexible display protrudes toward the first support plate and the second support plate. According to an embodiment, the first support plate 710, 710-1, 710-2, 710-3, 710-4, or 710-5 may allow the second housing part and the third housing part to rotate in a first direction identical to the rotation direction of the first rotating arm in a first section of the entire section from the unfolded state to the folded state, and rotate in a second direction opposite to the rotation direction of the first rotating arm in a second section of the entire section.

According to an embodiment, the second support plate 720, 720-1, 720-2, 720-3, 720-4, and 720-5 may allow the second housing part and the third housing part to rotate in the second direction identical to the rotation direction of the second rotating arm in the first section of the entire section from the unfolded state to the folded state, and rotate in the first direction opposite to the rotation direction of the second rotating arm in the second section of the entire section.

According to an embodiment, the first rotating arm 420 may include the first accommodating part 421. The first support plate 710, 710-1, 710-2, 710-3, 710-4, and 710-5 may include the first connection part 730, 730a-1, 730b-1, 730c-1, 730a-2, 730b-2, 730c-2, 730a-3, 730b-3, 730c-3, 730a-4, 730b-4, 730a-5, or 730b-5 that is rotatably inserted into the first accommodating part. The second rotating arm 430 may include the second accommodating part 431. The second support plate 720, 720-1, 720-2, 720-3, 720-4, or 720-5 may include the second connection part 740, 740a-1, 740b-1, 740c-1, 740a-2, 740b-2, 740c-2, 740a-3, 740b-3, 740c-3, 740a-4, 740b-4, 740a-5, or 740b-5 that is rotatably inserted into the second accommodating part.

According to an embodiment, the first hinge assembly 400 may include the first anti-separation cap 428 coupled to the first accommodating part to support the first connection part, and the second anti-separation cap 429 coupled to the second accommodating part to support the second connection part.

According to an embodiment, the first connection part 730 may extend from the first side of the first support plate, and include the first rotating protrusion 731 and the second rotating protrusion 732 protruding from both ends of the first extension part, respectively. The first accommodating part 421 may provide the first guide space and the second guide space together with the first anti-separation cap to make the first rotating protrusion and the second rotating protrusion rotatable, respectively.

According to an embodiment, the second connection part 740 may extend from the first side of the second support plate and include the third rotating protrusion 741 and the fourth rotating protrusion 742 protruding at both ends of the second extension part, respectively. The second accommodating part 431 may provide the third guide space and the fourth guide space together with the second anti-separation cap to make the third rotating protrusion and the fourth rotating protrusion rotatable, respectively.

According to an embodiment, the first guide space may be formed by the first sliding groove 422b of the first accommodating part 421 and the first cover protrusion 428a of the first anti-separation cap 428 covering the first sliding groove.

According to an embodiment, the second guide space may be formed by the second sliding groove 422c of the first accommodating part 421 and the second cover protrusion 428b of the first anti-separation cap 428 covering the second sliding groove.

According to an embodiment, the third guide space may be formed by the third sliding groove 432b of the second accommodating part 431 and the third cover protrusion of the second anti-separation cap 429 covering the third sliding groove.

According to an embodiment, the fourth guide space may be formed by the fourth sliding groove 432c of the second accommodating part 431 and the second cover protrusion of the second anti-separation cap 429 covering the fourth sliding groove.

According to an embodiment, the first rotating protrusion 731 and the second rotating protrusion 732 may rotate within the first sliding groove and second sliding groove of the first accommodating part, respectively.

According to an embodiment, the third rotating protrusion 741 and the fourth rotating protrusion 742 may rotate within the third sliding groove and fourth sliding groove of the second accommodating part.

According to an embodiment, the first support plate 710, 710-1, 710-2, 710-3, 710-4, or 710-5 may be restricted from rotating at the first position by interference between the first connection part and the first stop surface 442d of the first accommodating part 421, and may be restricted from rotating in the second position by interference between the first connection part and the second stop surface 428c of the first anti-separation cap 4238.

According to an embodiment, the second support plate 720, 720-1, 720-2, 720-3, 720-4, or 720-5 may be restricted from rotating at the first position by interference between the second connection part and the third stop surface of the second accommodating part 431, and to be restricted from rotating at the second position by interference between the second connection part and the second stop surface 429c of the second anti-separation cap 429.

According to an embodiment, the first support plate 710, 710-1, 710-2, 710-3, 710-4, or 710-5 may allow the front end of the first support plate to rotate in the second direction by sliding on the first contact surface 417 provided on the upper surface of the first fixing bracket in the second section.

According to an embodiment, the second support plate 720, 720-1, 720-2, 720-3, 720-4, or 720-5 may allow the front end of the second support plate to rotate in the first direction by sliding on the second contact surface 418 provided on the upper surface of the first fixing bracket in the second section.

According to an embodiment, the first contact surface 417 and the second contact surface 418 may be formed symmetrically with respect to the center of the first fixing bracket 410.

According to an embodiment, each of the first contact surface 417 and the second contact surface 418 may include a rounded surface.

According to an embodiment, the front end of the first support plate 710, 710-1, 710-2, 710-3, 710-4, or 710-5 may have the first chamfered surface 711.

According to an embodiment, the front end of the second support plate 720, 720-1, 720-2, 720-3, 720-4, or 720-5 may have the second chamfered surface.

According to an embodiment, the front end of the first support plate 710, 710-1, 710-2, 710-3, 710-4, or 710-5 may have the convex first rounded surface 711-1.

According to an embodiment, the front end of the second support plate 720, 720-1, 720-2, 720-3, 720-4, or 720-5 may have the convex second rounded surface.

According to an embodiment, the first support plate 710, 710-1, 710-2, 710-3, 710-4, or 710-5 may allow the front end of the first support plate to rotate in the second direction by sliding on the contact protrusion 162-4, 163-4, or 164-4 provided on an inner surface of the second hinge cover 161-4 in the second section.

According to an embodiment, the second support plate 720, 720-1, 720-2, 720-3, 720-4, or 720-5 may allow the front end of the second support plate to rotate in the first direction by sliding on the contact protrusion 162-4, 163-4, or 164-4 provided on the inner surface of the second hinge cover 161-4 in the second section.

According to an embodiment, the first support plate 710-5 may include the first rotation restriction protrusion 713a-5 or 713b-5 provided at the front end of the first support plate to restrict rotation toward the flexible display at the first position.

According to an embodiment, the second support plate 720-5 may include the second rotation restriction protrusion 723a-5 or 723b-5 provided at the front end of the second support plate to restrict rotation toward the flexible display at the first position.

According to an embodiment, the first rotation restriction protrusion 713a-5 or 713b-5 and the second rotation restriction protrusion 723a-5 or 723b-5 may contact each other at the first position.

According to an embodiment, the first rotation restriction protrusion 713a-5 or 713b-5 may protrude toward the second hinge cover from the front end of the first support plate.

According to an embodiment, the second rotation restriction protrusion 723a-5 or 723b-5 may protrude toward the second hinge cover from the front end of the second support plate.

According to an embodiment, the first support plate 710-6 may include the first living hinge 710c-6 formed along the length direction of the first support plate to make the left and right sides of the first support plate foldable.

According to an embodiment, the second support plate 720-6 may include the second living hinge 720c-6 formed along the length direction of the second support plate to make the left and right sides of the second support plate foldable.

According to an embodiment, the first rotating arm 420 may rotate around the first rotation axis A1.

According to an embodiment, the second rotating arm 430 may rotate around the second rotation axis A2 parallel to the first rotation axis.

According to an embodiment, the first support plate 710, 710-1, 710-2, 710-3, 710-4, 710-5, or 710-6 may rotate around the third rotation axis A3 that is disposed to be parallel to the first rotation axis A1 and offset toward the second rotation axis A2 from the first rotation axis A1.

According to an embodiment, the second support plate 720, 720-1, 720-2, 720-3, 720-4, 720-5, or 720-6 may rotate around the fourth rotation axis A4 that is disposed to be parallel to the second rotation axis A2 and offset toward the first rotation axis A1 from the second rotation axis A2.

According to an embodiment, the first fixing bracket 410 may include the pair of first rotation guide grooves 413 spaced apart along the first rotation axis on the first side of the first fixing bracket, and the pair of second rotation guide grooves 414 spaced apart along the second rotation axis on the second side of the first fixing bracket.

According to an embodiment, the first rotating arm 420 may include the pair of first rotation rails rotatably connected to the pair of first rotation guide grooves 413, respectively.

According to an embodiment, the second rotating arm 430 may include the pair of second rotation rails rotatably connected to the pair of second rotation guide grooves 414, respectively.

According to an embodiment, the first support plate 710, 710-1, 710-2, 710-3, 710-4, 710-5, or 710-6 and the second support plate 720, 720-1, 720-2, 720-3, 720-4, 720-5, or 720-6 may be symmetrically formed with each other.

According to an embodiment, the first connection part 730, 730a-1, 730b-1, 730c-1, 730a-2, 730b-2, 730c-2, 730a-3, 730b-3, 730c-3, 730a-4, 730b-4, 730a-5, or 730b-5 and the second connection part 740, 740a-1, 740b-1, 740c-1, 740a-2, 740b-2, 740c-2, 740a-3, 740b-3, 740c-3, 740a-4, 740b-4, 740a-5, or 740b-5 may be symmetrically formed with each other.

According to an embodiment, the width of the first support plate 710 may be greater than the width of the first rotating protrusion 731.

According to an embodiment, the gap between the first support plate 710 and the first rotating protrusion 731 in the width direction may be less than the width of the first rotating protrusion 731.

According to an embodiment, the width of the second support plate 720 may be greater than the width of the second rotating protrusion.

According to an embodiment, the gap between the second support plate 720 and the second rotating protrusion in the width direction may be less than the width of the second rotating protrusion.

According to an embodiment, the thickness of the first support plate 710 may be less than the thickness of the first rotating protrusion 731.

According to an embodiment, the gap between the first support plate 710 and the first rotating protrusion 731 in the thickness direction may be less than the thickness of the first support plate 710.

According to an embodiment, the thickness of the second support plate 720 may be less than the thickness of the second rotating protrusion.

According to an embodiment, the gap between the second support plate 720 and the second rotating protrusion in the thickness direction may be less than the thickness of the second support plate 720.

According to an embodiment, the first housing part, the second housing part, the first anti-separation cap 428-1, and the second anti-separation cap may each be made of the metal material. The first anti-separation cap 428-1 and the first rotating arm 420a-1 may be welded to each other. The second anti-separation cap and the second rotating arm may be welded to each other.

According to an embodiment, the second hinge structure 160 may include the second hinge assembly 500 rotatably connecting the first housing part and the second housing part to each other.

According to an embodiment, the second hinge assembly 500 may include the second fixing bracket fixed to the second hinge cover 161; the third rotating arm having one end rotatably connected to the first side of the second fixing bracket and the other end fixed to the first housing part, and including the third accommodating part; and the fourth rotating arm having one end rotatably connected to the second side of the second fixing bracket and the other end fixed to the second housing part, and including the fourth accommodating part.

According to an embodiment, the first support plate 710 may include the third connection part rotatably connected to the third accommodating part.

According to an embodiment, the second support plate 720 may include the fourth connection part rotatably connected to the fourth accommodating part 531.

According to an embodiment, the width of the second hinge structure 160 may greater than the width of the first hinge structure 150.

According to an embodiment, the foldable electronic apparatus 100 may include: the first housing part; the second housing part; the flexible display 140 accommodated in the first housing part or the second housing part; and a hinge assembly 400 rotatably connecting the first housing part and the second housing part to each other.

The hinge assembly 400 may include the first fixing bracket 410 including the first rotation guide groove and the second rotation guide groove; the first rotating arm 420 rotating around the first rotation axis A1 in linkage with the first rotation guide groove of the first fixing bracket, connected to the first housing part, and having the first accommodating part provided therein; the second rotating arm 430 rotating around the second rotation axis A2 in linkage with the second rotation guide groove of the first fixing bracket, connected to the second housing part, and having the second accommodating part provided therein; the first support plate 710 including the first connection part at least partially accommodated in the first accommodating part, and rotating around the third rotation axis included in the first connection part; and the second support plate 720 including the second connection part at least partially accommodated in the second accommodating part, and rotating around the fourth rotation axis() included in the second connection part. The first support plate 710 and the second support plate 720 may support a portion of the flexible display if the first housing part and the second housing part are in the fully unfolded state. The first rotation axis A1 may be a virtual rotation axis serving as the rotational center of the first rotating arm 420. The second rotation axis A2 may be a virtual rotation axis serving as the rotational center of the second rotating arm 430.

According to an embodiment, while the first housing part and the second housing part are folded in a direction in which the housing parts face each other, the rotation angle by which the first rotating arm 420 rotates may be greater than the rotation angle by which the first support plate 710 rotates.

According to an embodiment, the first rotating arm 420 may include the first rotation rail 425 corresponding to the first rotation guide groove in a first surface of the first rotating arm, and include the first accommodating part 421 in a second surface of the first rotating arm, which is opposite to the first surface of the first rotating arm.

According to an embodiment, the hinge assembly 400 may include the anti-separation cap 428. The anti-separation cap 428 may at least partially cover the first connection part 730 of the support plate 710 seated on the first accommodating part 421.

According to an embodiment, the first rotating protrusion 731 and the second rotating protrusion 732 may be disposed at each end of the first connection part 730, respectively. The first rotating protrusion 731 and the second rotating protrusion 732 may be disposed between the first accommodating part 421 and the anti-separation cap 428.

According to an embodiment, the first support plate 710 may include the first connection part 730 disposed at a first end, and may rotate as its second end, opposite to the first end, comes into contact with a first part of the first fixing bracket 410 during at least a partial section in which the first housing part and the second housing part are folded in the direction in which the housing parts face each other.

According to an embodiment, at least a portion of the first part of the first fixing bracket 410 may be formed as a rounded surface.

According to an embodiment, at least one corner of a second end of the first support plate 710 may include the rounded surface 711-1 or the chamfered surface 711.

According to an embodiment, the hinge assembly 400 may include: the second fixing bracket including the third rotation guide groove and the fourth rotation guide groove; the third rotating arm rotating around the virtual first rotation axis A1 in linkage with the third rotation guide groove of the second fixing bracket, mechanically connected to the first housing part, and having the third accommodating part provided therein; and the fourth rotating arm rotating around the virtual second rotation axis A2 in linkage with the fourth rotation guide groove of the second fixing bracket, connected to the second housing part, and having the fourth accommodating part provided therein.

According to an embodiment, the first support plate 710 may include the third connection part at least partially accommodated in the third accommodating part, and may rotate around the third rotation axis A3 included in the third connection part.

According to an embodiment, the second support plate 720 may include the fourth connection part at least partially accommodated in the fourth accommodating part, and rotate around the fourth rotation axis A4 included in the fourth connection part.

Although the electronic apparatus 100 has been described above as including first, second, and third housing parts 110, 120, and 130, wherein the second housing part 120 and third housing part 130 are connected by second hinge structure 160, it will be appreciated that the hinge structure described in relation to second hinge structure 160 may also be used in an electronic apparatus comprising only two housing parts (i.e. the electronic device 100 may comprise a first housing part and second housing part connected by a hinge structure according to the second hinge structure 160 described above). It will also be appreciated that the hinge structure described in relation to second hinge structure 160 may also be used in an electronic apparatus comprising any number of housing parts and may be included more than one time in such a device (that is, an electronic apparatus may include more than one pair of housing parts connected by hinge structures according to the second hinge structure 160 described above). For example, the hinge structure described in relation to second hinge structure 160 may be used to connect two or more housing parts in any electronic apparatus where a wide hinge structure is required or desirable.

In a first example, there is provided a foldable electronic apparatus comprising: a foldable housing configured to include a first housing part, a second housing part and a third housing part; a first hinge structure configured to rotatably connect the first housing part and the second housing part with each other; a second hinge structure configured to rotatably connect the second housing part and the third housing part with each other and include a first hinge assembly; and a flexible display disposed across the first housing part and the second housing part; wherein the hinge assembly includes: a first fixing bracket; a first rotating arm having one end rotatably connected to a first side of the first fixing bracket and the other end fixed to the first housing part; a second rotating arm having one end rotatably connected to a second side of the first fixing bracket and the other end fixed to the second housing part; a first support plate rotatably connected to the first rotating arm; and a second support plate rotatably connected to the second rotating arm; and wherein the first support plate and the second support plate are configured to: support the flexible display in an unfolded state where the first housing part and the second housing part are unfolded; and be spaced apart from each other in linkage with rotation of the first housing part and the second housing part as the first housing part and the second housing part move from the unfolded state to a folded state where the first housing part and the second housing part are folded.

In a second example, there is provided the apparatus of the first example, further comprising a first hinge cover configured to cover the first hinge structure and a second hinge cover configured to cover the second hinge structure, wherein the first support plate and the second support plate are configured to retract toward the hinge cover to be spaced apart from the flexible display while a folding portion of the flexible display protrudes toward the first support plate and the second support plate as the electronic apparatus is folded.

In an third example, there is provided the apparatus of the first or second examples, wherein the first support plate is configured to rotate in a first direction identical to a rotation direction of the first rotating arm in a first section of the rotation from the unfolded state to the folded state of the second housing part and the third housing part, and rotate in a second direction opposite to the rotation direction of the first rotating arm in a second section of rotation from the unfolded state to the folded state; and wherein the second support plate is configured to rotate in the second direction identical to a rotation direction of the second rotating arm in the first section of the rotation from the unfolded state to the folded state, and rotate in the first direction opposite to the rotation direction of the second rotating arm in the second section of the rotation from the unfolded state to the folded state.

In a fourth example, there is provided the apparatus of the third example, wherein the first support plate is configured to allow a first end of the first support plate to rotate in the second direction by sliding on a first contact surface provided on a first surface of the first fixing bracket in the second section of the rotation from the unfolded state to the folded state; and wherein the second support plate is configured to allow a first end of the second support plate to rotate in the first direction by sliding on a second contact surface provided on the first surface of the first fixing bracket in the second section of the rotation from the unfolded state to the folded state.

In a fifth example, there is provided the apparatus of the third example, wherein the first support plate is configured to allow a first end of the first support plate to rotate in the second direction by sliding on a contact protrusion provided on a first surface of the second hinge cover in the second section of the rotation from the unfolded state to the folded state; and wherein the second support plate is configured to allow a first end of the second support plate to rotate in the first direction by sliding on the contact protrusion provided on the first surface of the second hinge cover in the second section of the rotation from the unfolded state to the folded state.

In a sixth example, there is provided the apparatus of the first examples, wherein the first rotating arm includes a first accommodating part; wherein the first support plate includes a first connection part rotatably inserted into the first accommodating part; wherein the second rotating arm includes a second accommodating part; wherein the second support plate includes a second connection part rotatably inserted into the second accommodating part, and wherein the hinge assembly further includes a first anti-separation cap coupled to the first accommodating part to retain the first connection part within the first accommodating part and a second anti-separation cap coupled to the second accommodating part to retain the second connection part within the second accommodating part.

In a seventh example, there is provided the apparatus of the sixth example, wherein the first housing part, the second housing part, the first anti-separation cap, and the second anti-separation cap are each made of a metal material; wherein the first anti-separation cap and the first rotating arm are configured to be welded to each other; and wherein the second anti-separation cap and the second rotating arm are configured to be welded to each other.

In a eighth example, there is provided the apparatus of the sixth or seventh example, wherein the first connection part includes: a first extension part extending from a first side of the first support plate; and a first rotating protrusion and a second rotating protrusion protruding from the first extension part; wherein the first accommodating part is configured to provide a first guide space and a second guide space together with the first anti-separation cap such that the first rotating protrusion can rotate within the first guide space and the second rotating protrusion can rotate within the second guide space; wherein the second connection part includes: a second extension part extending from a first side of the second support plate; and a third rotating protrusion and a fourth rotating protrusion protruding from the second extension part,; and wherein the second accommodating part is configured to provide a third guide space and a fourth guide space together with the second anti-separation cap such that the third rotating protrusion can rotate within the third guide space and the fourth rotating protrusion can rotate within the fourth guide space.

In a ninth example, there is provided the apparatus of the eighth example, wherein the first guide space is formed by a first sliding groove of the first accommodating part and a first cover protrusion of the first anti-separation cap configured to cover the first sliding groove; wherein the second guide space is formed by a second sliding groove of the first accommodating part and a second cover protrusion of the first anti-separation cap configured to cover the second sliding groove; wherein the third guide space is formed by a third sliding groove of the second accommodating part and a third cover protrusion of the second anti-separation cap configured to cover the third sliding groove; and wherein the fourth guide space is formed by a fourth sliding groove of the second accommodating part and a fourth cover protrusion of the second anti-separation cap configured to cover the fourth sliding groove.

In a tenth example, there is provided the apparatus of the sixth examples, wherein the first support plate is configured to be restricted from rotating at the first position by interference between the first connection part and a first stop surface of the first accommodating part, and to be restricted from rotating at the second position by interference between the first connection part and a second stop surface of the first anti-separation cap; and wherein the second support plate is configured to be restricted from rotating at the first position by interference between the second connection part and a third stop surface of the second accommodating part, and o be restricted from rotating at the second position by interference between the second connection part and a fourth stop surface of the second anti-separation cap.

In a eleventh example, there is provided the apparatus of the first examples, wherein the first support plate further includes a first rotation restriction protrusion provided at a first end of the first support plate to restrict rotation of the first support plate toward the flexible display at the first position; wherein the second support plate further includes a second rotation restriction protrusion provided at a first end of the second support plate to restrict rotation of the second support plate toward the flexible display at the first position; wherein the first rotation restriction protrusion and the second rotation restriction protrusion are configured to contact each other at the first position; wherein the apparatus further comprises a hinge cover configured to cover the first hinge structure and a second hinge cover configured to cover the second hinge structure, wherein the first rotation restriction protrusion is configured to protrude toward the second hinge cover from the first end of the first support plate; and wherein the second rotation restriction protrusion is configured to protrude toward the second hinge cover from the first end of the second support plate.

In a twelfth example, there is provided the apparatus of the first examples, wherein the first support plate further includes a first living hinge to make the first support plate foldable along an axis parallel to the folding axis of the foldable housing; and wherein the second support plate further includes a second living hinge formed along a length direction of the second support plate to make left and right sides of the second support plate foldable along an axis parallel to the folding axis of the foldable housing.

In a thirteenth example, there is provided the apparatus of the first examples, wherein the first rotating arm is configured to rotate around a first rotation axis; wherein the second rotating arm is configured to rotate around a second rotation axis parallel to the first rotation axis; wherein the first support plate is configured to rotate around a third rotation axis that is disposed to be parallel to the first rotation axis and offset toward the second rotation axis from the first rotation axis; and wherein the second support plate is configured to rotate around a fourth rotation axis that is disposed to be parallel to the second rotation axis and offset toward the first rotation axis from the second rotation axis.

In a fourteenth example, there is provided the apparatus of the thirteenth example, wherein the first fixing bracket includes a pair of first rotation guide grooves spaced apart along the first rotation axis on a first side of the first fixing bracket, and a pair of second rotation guide grooves spaced apart along the second rotation axis on a second side of the first fixing bracket; wherein the first rotating arm includes a pair of first rotation rails rotatably connected to the pair of first rotation guide grooves, respectively; and wherein the second rotating arm includes a pair of second rotation rails rotatably connected to the pair of second rotation guide grooves, respectively.

In a fifteenth example, there is provided the apparatus of any of the first to fourteenth examples, wherein the first hinge structure and the second hinge structure are configured to enable the foldable housing to fold into a state in which the third housing is layered between the first housing and the second housing.

Hereinabove, although the embodiments are described with reference to the specific drawings, the present disclosure may be variously modified and changed from the above description by those skilled in the art to which the present disclosure pertains. For example, an appropriate result may be achieved even if the described techniques are performed in an order different from that of the described method, and/or the described technologies are performed in a different order than the described method, and/or the components such as the described system, structure, device, circuit and the like are coupled or combined to each other in a form different from that of the described method, or the components are replaced or substituted by other components or equivalents. Therefore, other implementations, other embodiments and those equivalent to the claims also fall within the scope of the claims to be described below.

## Claims

1. A foldable electronic apparatus comprising:

   a foldable housing configured to include a first housing part, a second housing part and a third housing part;
   a first hinge structure configured to rotatably connect the first housing part and the second housing part with each other;
   a second hinge structure configured to rotatably connect the second housing part and the third housing part with each other and include a first hinge assembly;
   a flexible display disposed across the first housing part, the second housing part and the third housing part;
   wherein the first hinge assembly includes:

   a first fixing bracket;
   a first rotating arm having one end rotatably connected to a first side of the first fixing bracket and the other end fixed to the second housing part;
   a second rotating arm having one end rotatably connected to a second side of the first fixing bracket and the other end fixed to the third housing part;
   a first support plate rotatably connected to the first rotating arm; and
   a second support plate rotatably connected to the second rotating arm; and
   wherein the first support plate and the second support plate are configured to:

support the flexible display in an unfolded state where the second housing part and the third housing part are unfolded; and

be spaced apart from each other in linkage with rotation of the second housing part and the third housing part as the second housing part and the third housing part move from the unfolded state to a folded state where the second housing part and the third housing part are folded.

2. The apparatus as claimed in claim 1, further comprising a first hinge cover configured to cover the first hinge structure and a second hinge cover configured to cover the second hinge structure,

wherein the first support plate and the second support plate are configured to retract toward the second hinge cover to be spaced apart from the flexible display while a folding portion of the flexible display protrudes toward the first support plate and the second support plate as the electronic apparatus is folded.

3. The apparatus as claimed in claim 2, wherein the first support plate is configured to rotate in a first direction identical to a rotation direction of the first rotating arm in a first section of the rotation from the unfolded state to the folded state of the second housing part and the third housing part, and rotate in a second direction opposite to the rotation direction of the first rotating arm in a second section of rotation from the unfolded state to the folded state; and

wherein the second support plate is configured to rotate in the second direction identical to a rotation direction of the second rotating arm in the first section of the rotation from the unfolded state to the folded state, and rotate in the first direction opposite to the rotation direction of the second rotating arm in the second section of the rotation from the unfolded state to the folded state.

4. The apparatus as claimed in claim 3, wherein the first support plate is configured to allow a first end of the first support plate to rotate in the second direction by sliding on a first contact surface provided on a first surface of the first fixing bracket in the second section of the rotation from the unfolded state to the folded state; and

wherein the second support plate is configured to allow a first end of the second support plate to rotate in the first direction by sliding on a second contact surface provided on the first surface of the first fixing bracket in the second section of the rotation from the unfolded state to the folded state.

5. The apparatus as claimed in claim 3, wherein the first support plate is configured to allow a first end of the first support plate to rotate in the second direction by sliding on a contact protrusion provided on a first surface of the second hinge cover in the second section of the rotation from the unfolded state to the folded state; and

wherein the second support plate is configured to allow a first end of the second support plate to rotate in the first direction by sliding on the contact protrusion provided on the first surface of the second hinge cover in the second section of the rotation from the unfolded state to the folded state.

6. The apparatus as claimed in claim 1, wherein the first rotating arm includes a first accommodating part;

wherein the first support plate includes a first connection part rotatably inserted into the first accommodating part;
wherein the second rotating arm includes a second accommodating part;
wherein the second support plate includes a second connection part rotatably inserted into the second accommodating part, and
wherein the first hinge assembly further includes a first anti-separation cap coupled to the first accommodating part to retain the first connection part within the first accommodating part and a second anti-separation cap coupled to the second accommodating part to retain the second connection part within the second accommodating part.

7. The apparatus as claimed in claim 6, wherein the first housing part, the second housing part, the first anti-separation cap, and the second anti-separation cap are each made of a metal material;

wherein the first anti-separation cap and the first rotating arm are configured to be welded to each other; and
wherein the second anti-separation cap and the second rotating arm are configured to be welded to each other.

8. The apparatus as claimed in claim 6 or 7, wherein the first connection part includes:

a first extension part extending from a first side of the first support plate; and
a first rotating protrusion and a second rotating protrusion protruding from the first extension part;
wherein the first accommodating part is configured to provide a first guide space and a second guide space together with the first anti-separation cap such that the first rotating protrusion can rotate within the first guide space and the second rotating protrusion can rotate within the second guide space;

wherein the second connection part includes:

a second extension part extending from a first side of the second support plate; and a third rotating protrusion and a fourth rotating protrusion protruding from the second extension part; and

wherein the second accommodating part is configured to provide a third guide space and a fourth guide space together with the second anti-separation cap such that the third rotating protrusion can rotate within the third guide space and the fourth rotating protrusion can rotate within the fourth guide space.

9. The apparatus as claimed in claim 8, wherein the first guide space is formed by a first sliding groove of the first accommodating part and a first cover protrusion of the first anti-separation cap configured to cover the first sliding groove;

wherein the second guide space is formed by a second sliding groove of the first accommodating part and a second cover protrusion of the first anti-separation cap configured to cover the second sliding groove;

wherein the third guide space is formed by a third sliding groove of the second accommodating part and a third cover protrusion of the second anti-separation cap configured to cover the third sliding groove; and

wherein the fourth guide space is formed by a fourth sliding groove of the second accommodating part and a fourth cover protrusion of the second anti-separation cap configured to cover the fourth sliding groove.

10. The apparatus as claimed in claim 1, wherein the first support plate is configured to be restricted from rotating at a first position by interference between the first connection part and a first stop surface of the first accommodating part, and to be restricted from rotating at a second position by interference between the first connection part and a second stop surface of the first anti-separation cap; and

wherein the second support plate is configured to be restricted from rotating at the first position by interference between the second connection part and a third stop surface of the second accommodating part, and o be restricted from rotating at the second position by interference between the second connection part and a fourth stop surface of the second anti-separation cap.

11. The apparatus as claimed in claim 10, wherein the first support plate further includes a first rotation restriction protrusion provided at a first end of the first support plate to restrict rotation of the first support plate toward the flexible display at the first position;

wherein the second support plate further includes a second rotation restriction protrusion provided at a first end of the second support plate to restrict rotation of the second support plate toward the flexible display at the first position;

wherein the first rotation restriction protrusion and the second rotation restriction protrusion are configured to contact each other at the first position;

wherein the apparatus further comprises a hinge cover configured to cover the first hinge structure and a second hinge cover configured to cover the second hinge structure,

wherein the first rotation restriction protrusion is configured to protrude toward the second hinge cover from the first end of the first support plate; and

wherein the second rotation restriction protrusion is configured to protrude toward the second hinge cover from the first end of the second support plate.

12. The apparatus as claimed in claim 1, wherein the first support plate further includes a first living hinge to make the first support plate foldable along an axis parallel to the folding axis of the foldable housing; and

wherein the second support plate further includes a second living hinge formed along a length direction of the second support plate to make left and right sides of the second support plate foldable along an axis parallel to the folding axis of the foldable housing.

13. The apparatus as claimed in claim 1, wherein the first rotating arm is configured to rotate around a first rotation axis;

wherein the second rotating arm is configured to rotate around a second rotation axis parallel to the first rotation axis;

wherein the first support plate is configured to rotate around a third rotation axis that is disposed to be parallel to the first rotation axis and offset toward the second rotation axis from the first rotation axis; and

wherein the second support plate is configured to rotate around a fourth rotation axis that is disposed to be parallel to the second rotation axis and offset toward the first rotation axis from the second rotation axis.

14. The apparatus as claimed in claim 13, wherein the first fixing bracket includes a pair of first rotation guide grooves spaced apart along the first rotation axis on a first side of the first fixing bracket, and a pair of second rotation guide grooves spaced apart along the second rotation axis on a second side of the first fixing bracket;

> wherein the first rotating arm includes a pair of first rotation rails rotatably connected to the pair of first rotation guide grooves, respectively; and wherein the second rotating arm includes a pair of second rotation rails rotatably connected to the pair of second rotation guide grooves, respectively.

15. The apparatus as claims in claim 1, wherein the first hinge structure and the second hinge structure are configured to enable the foldable housing to fold into a state in which the third housing is layered between the first housing and the second housing.

# FIG. 1

# FIG. 2

# FIG. 3

100c

# FIG. 4

# FIG. 5

# FIG. 6A

# FIG. 6B

# FIG. 7

# FIG. 8

# FIG. 9

# FIG. 10

# FIG. 11

# FIG. 12

# FIG. 13

# FIG. 14

# FIG. 15

# FIG. 16

# FIG. 17

# FIG. 18

400

420    421    A3    710    720    A4    431    430

428    731,732    429    410    741,742

D-D'

A1    710    720    A2

420    410    430

E-E'

z

y    x

# FIG. 19

# FIG. 20

# FIG. 21

# FIG. 22

FIG. 23

# FIG. 24A

# FIG. 24B

# FIG. 24C

# FIG. 25A

# FIG. 25B

# FIG. 25C

# FIG. 26A

# FIG. 26B

731a-5

740a-5

730a-5

710-5

720-5

y

z    x

730b-5

740b-5

732a-5

# FIG. 27

# FIG. 28A

# FIG. 28B

428-1

420a-1

426-1

420-1

z

y

x

# FIG. 29

410-2

417a-2

418a-2

417b-2

418b-2

417-2

418-2

z

y

x

# FIG. 30

# FIG. 31

# FIG. 32

710-4  162-4  720-4

711-4  721-4  161-4

162a-4, 163a-4, 164a-4  162b-4, 163b-4, 164b-4

z

y  x

# FIG. 33

710-5

710a-5

720-5

713a-5

720a-5

723a-5

713b-5

723b-5

z

y

x

# FIG. 34

# FIG. 35

# FIG. 36

160-6

140-6

420-6

430-6

400-6

710a-6

710c-6

710b-6

410-6

720a-6

720c-6

720b-6

720-6

710-6

145-6

z

y

x

**TRANSLATION**

### INTERNATIONAL SEARCH REPORT

| International application No. |
| --- |
| **PCT/KR2025/014097** |

| A. | CLASSIFICATION OF SUBJECT MATTER |
| --- | --- |
| | **G06F 1/16**(2006.01)i; **G09F 9/30**(2006.01)i; **F16C 11/04**(2006.01)i; **H05K 5/02**(2006.01)i |

According to International Patent Classification (IPC) or to both national classification and IPC

| B. | FIELDS SEARCHED |
| --- | --- |

Minimum documentation searched (classification system followed by classification symbols)

G06F 1/16(2006.01); F16C 11/04(2006.01); G09F 9/30(2006.01); H04M 1/02(2006.01); H04N 21/431(2011.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 폴더블(foldable), 제3 하우징(third housing), 힌지(hinge), 플렉서블 디스플레이 (flexible display), 회전 암(rotating arm), 지지 플레이트(support plate)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2022-0046143 A (SAMSUNG ELECTRONICS CO., LTD.) 14 April 2022 (2022-04-14) paragraphs [0045], [0085], [0130]-[0132]; and figures 5-6, 15 | 1-2,15 |
| A | | 3-14 |
| Y | KR 10-2024-0039543 A (SAMSUNG ELECTRONICS CO., LTD.) 26 March 2024 (2024-03-26) paragraphs [0058], [0067], [0071], [0077]; claim 1; and figures 5-7 | 1-2,15 |
| Y | KR 10-2020-0132362 A (SAMSUNG ELECTRONICS CO., LTD.) 25 November 2020 (2020-11-25) figures 14d, 14g | 15 |
| A | KR 10-2020-0131662 A (SAMSUNG ELECTRONICS CO., LTD.) 24 November 2020 (2020-11-24) paragraphs [0057]-[0063]; and figures 4-5 | 1-15 |
| A | KR 10-2450835 B1 (WUHAN CHINA STAR OPTOELECTRONICS SEMICONDUCTOR DISPLAY TECHNOLOGY CO., LTD.) 04 October 2022 (2022-10-04) paragraphs [0024]-[0035]; and figures 1-3 | 1-15 |

☐ Further documents are listed in the continuation of Box C.  ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **16 December 2025** | **16 December 2025** |

| Name and mailing address of the ISA/KR | Authorized officer |
| --- | --- |
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2025/014097**

| Patent document cited in search report | | | Publication date (day/month/year) | Patent family member(s) | | | Publication date (day/month/year) |
|---|---|---|---|---|---|---|---|
| KR | 10-2022-0046143 | A | 14 April 2022 | WO | 2022-075568 | A1 | 14 April 2022 |
| KR | 10-2024-0039543 | A | 26 March 2024 | CN | 119923606 | A | 02 May 2025 |
| | | | | EP | 4567551 | A1 | 11 June 2025 |
| | | | | US | 2025-0203793 | A1 | 19 June 2025 |
| | | | | WO | 2024-063277 | A1 | 28 March 2024 |
| KR | 10-2020-0132362 | A | 25 November 2020 | US | 2020-0364021 | A1 | 19 November 2020 |
| | | | | WO | 2020-235885 | A1 | 26 November 2020 |
| KR | 10-2020-0131662 | A | 24 November 2020 | EP | 3850607 | A1 | 21 July 2021 |
| | | | | EP | 3850607 | B1 | 25 September 2024 |
| | | | | US | 11178264 | B2 | 16 November 2021 |
| | | | | US | 2020-0366770 | A1 | 19 November 2020 |
| | | | | WO | 2020-231072 | A1 | 19 November 2020 |
| KR | 10-2450835 | B1 | 04 October 2022 | CN | 111637147 | A | 08 September 2020 |
| | | | | CN | 111637147 | B | 01 June 2021 |
| | | | | EP | 4155560 | A1 | 29 March 2023 |
| | | | | EP | 4155560 | A4 | 08 May 2024 |
| | | | | JP | 2022-536883 | A | 22 August 2022 |
| | | | | JP | 7235425 | B2 | 08 March 2023 |
| | | | | KR | 10-2021-0145118 | A | 01 December 2021 |
| | | | | US | 11698662 | B2 | 11 July 2023 |
| | | | | US | 2022-0283608 | A1 | 08 September 2022 |
| | | | | WO | 2021-232542 | A1 | 25 November 2021 |

Form PCT/ISA/210 (patent family annex) (July 2022)